# EUROPEAN PATENT APPLICATION

(11) **EP 4 608 106 A1**
(43) Date of publication of application: **27.08.2025**
(21) Application number: 25159140.0
(22) Date of filing: 20.02.2025
(51) Int. Cl.: H10K 50/19, H10K 59/122, H10K 59/131, H10K 59/80

(54) **DISPLAY DEVICE, METHOD FOR FABRICATING THE SAME AND HEAD MOUNTED DISPLAY DEVICE INCLUDING THE SAME**

(30) Priority: 23.02.2024 KR 20240026231
(71) Applicant: Samsung Display Co., Ltd., Yongin-si, Gyeonggi-do 17113 (KR)
(72) Inventor: LEE, Jae Been, Yongin-si (KR); PARK, Na Rae, Yongin-si (KR); KANG, Sin Chul, Yongin-si (KR); SONG, Dae Ho, Yongin-si (KR); JUNG, Lok Gam, Yongin-si (KR); CHO, Mi Yeon, Yongin-si (KR); CHOI, Ye Hwan, Yongin-si (KR)
(74) Representative: Marks & Clerk LLP

(57) **Abstract**

The present disclosure relates to a display device, a method for fabricating the same and a head mounted display device including the same. A display device includes: a substrate including a display area and a non-display area; first electrodes spaced from each other on the substrate in the display area; a power connection electrode on the substrate in the non-display area; a pixel defining film in the display area and the non-display area and including first openings overlapping the first electrodes, and a second opening overlapping the power connection electrode; light emitting stacks on the first electrode in the display area; and a second electrode on the pixel defining film and the light emitting stack, the pixel defining film includes a first pixel defining film, a second pixel defining film on the first pixel defining film, and a third pixel defining film on the second pixel defining film.

## Description

### BACKGROUND

### 1. Field

The present disclosure relates to a display device, a method for fabricating the same and a head mounted display device including the same.

### 2. Description of the Related Art

A head mounted display device (HMD) is an image display device that is worn on a user's head in the form of glasses or helmets to form a focus at a close distance in front of the user's eyes. The head mounted display device may implement virtual reality (VR) or augmented reality (AR).

The head mounted display device magnifies an image displayed on a small display device by using a plurality of lenses, and displays the magnified image. Therefore, the display device applied to the head mounted display device may need to provide high-resolution images, for example, images with a resolution of 3000 Pixels Per Inch (PPI) or higher. To this end, an organic light emitting diode on silicon (OLEDoS), which is a high-resolution small organic light emitting display device, is used as the display device applied to the head mounted display device. The OLEDoS is an image display device in which an organic light emitting diode (OLED) is disposed on a semiconductor wafer substrate on which a complementary metal oxide semiconductor (CMOS) is disposed.

### SUMMARY

Aspects of the present disclosure provide a display device including openings of different shapes in a pixel defining film.

According to one or more embodiments of the present disclosure, a display device includes: a substrate including a display area and a non-display area around the display area; a plurality of first electrodes spaced from each other on the substrate in the display area; a power connection electrode on the substrate in the non-display area; a pixel defining film in the display area and the non-display area and including a plurality of first openings overlapping the first electrodes, and a second opening overlapping the power connection electrode; a plurality of light emitting stacks on the first electrode in the display area; and a second electrode on the pixel defining film and the light emitting stack, wherein the pixel defining film includes a first pixel defining film, a second pixel defining film on the first pixel defining film, and a third pixel defining film on the second pixel defining film, and the second pixel defining film is recessed more inward than the third pixel defining film in the first opening, and lateral sides of the first pixel defining film, the second pixel defining film, and the third pixel defining film are at a same plane in the second opening.

In one or more embodiments, a thickness of a portion of the first electrode overlapping the first opening may be smaller than a thickness of a portion of the power connection electrode overlapping the second opening.

In one or more embodiments, a first thickness of a portion of the first electrode overlapping the first opening may be smaller than a second thickness of an edge portion of the first electrode.

In one or more embodiments, an area of the portion of the first electrode having the first thickness may be greater than an area of a portion of the first electrode penetrated by the first opening of the first pixel defining film, and the first pixel defining film may include a tip structure on the first electrode.

In one or more embodiments, the first electrode may include a base layer, an intermediate layer on the base layer, and an upper layer on the intermediate layer. A fourth thickness of a portion of the upper layer that overlaps the first opening may be smaller than a fifth thickness of an edge portion of the upper layer.

In one or more embodiments, the base layer may include Ti or ITO, the intermediate layer may include Al or Ag, and/or the upper layer may include TiN or ITO.

In one or more embodiments, the display device may further include an insulating layer on the substrate. The first electrode and the power connection electrode may be directly on the insulating layer.

In one or more embodiments, the pixel defining film may further include a fourth pixel defining film on the third pixel defining film. A fifth pixel defining film may be on the fourth pixel defining film. The fourth pixel defining film may be recessed more inward than the fifth pixel defining film in the first opening.

In one or more embodiments, a sidewall of the second opening of the pixel defining film may have a smooth surface. The second electrode may cover the second opening and may be connected to the power connection electrode.

In one or more embodiments, the light emitting stack may include a first light emitting stack, a second light emitting stack on the first light emitting stack, and a third light emitting stack on the second light emitting stack. The first light emitting stack and the second light emitting stack may be in the first opening. The first light emitting stacks and the second light emitting stacks may be in the plurality of first openings, which may be adjacent to each other and may be different from each other, and may in some examples be not connected to each other.

In one or more embodiments, each of the first pixel defining film, the second pixel defining film, and the third pixel defining film may include a silicon oxide or silicon nitride-based inorganic insulating material. The pixel defining film may include layers including different materials that are alternately stacked.

In one or more embodiments, the display device may further include a plurality of dam structures in the non-display area. The plurality of dam structures may be around the display area. The plurality of dam structures may be around an encapsulation layer on the second electrode. Each of the plurality of dam structures may have a trench shape penetrating the pixel defining film.

In one or more embodiments, the encapsulation layer may include a first inorganic encapsulation layer on the second electrode and may be beyond the dam structure. The encapsulation layer may include an organic encapsulation layer on the first inorganic encapsulation layer without covering an outermost dam structure from among the plurality of dam structures. The encapsulation layer may include a second inorganic encapsulation layer on the organic encapsulation layer and the first inorganic encapsulation layer.

In one or more embodiments, the display device may further include a plurality of color filters on the encapsulation layer and each overlapping the first electrode. The display device may include a plurality of lenses on the color filters and in the display area. The display device may include a cover layer on the lenses.

According to one or more embodiments of the present disclosure, a method for fabricating a display device, includes: forming a first electrode and a power connection electrode on a substrate, and forming a first pixel defining film, a second pixel defining film, and a third pixel defining film covering the first electrode and the power connection electrode; performing a first etching process of partially etching a portion of the second pixel defining film and the third pixel defining film overlapping the first electrode; performing a second etching process of etching a portion of the second pixel defining film remaining in the first etching process and forming a tip structure in which a lateral side of the third pixel defining film protrudes beyond the second pixel defining film; and performing a third etching process of etching the first pixel defining film, the second pixel defining film, and the third pixel defining film to form a first opening exposing a top surface of the first electrode and a second opening exposing a top surface of the power connection electrode, wherein the first electrode has a thickness of a portion overlapping the first opening, which is smaller than a thickness of a portion overlapping the second opening of the power connection electrode.

In one or more embodiments, a tip structure of the first pixel defining film and the third pixel defining film may be in the first opening, and lateral sides of the first pixel defining film, the second pixel defining film, and the third pixel defining film may be at a same plane in the second opening.

In one or more embodiments, the first electrode may include a base layer, an intermediate layer on the base layer, and an upper layer on the intermediate layer, and a thickness of a portion of the upper layer overlapping the first opening may be smaller than a thickness of an edge portion of the upper layer.

In one or more embodiments, the second etching process may be performed as a wet etching process.

In one or more embodiments, in the third etching process, the first pixel defining film may overlap the first electrode, and a part of the first electrode may be etched while the first pixel defining film, the second pixel defining film, and the third pixel defining film overlapping the power connection electrode are etched.

According to one or more embodiments of the present disclosure, a head mounted display device includes: a frame mountable on a user's body and corresponding to left and right eyes; a plurality of display devices in the frame; and an eyepiece on each of the plurality of display devices, wherein the display device includes: a substrate including a display area and a non-display area around the display area; a plurality of first electrodes spaced from each other on the substrate in the display area; a power connection electrode on the substrate in the non-display area; a pixel defining film in the display area and the non-display area and including a plurality of first openings overlapping the first electrodes, and a second opening overlapping the power connection electrode; a plurality of light emitting stacks on the first electrode in the display area; and a second electrode on the pixel defining film and the light emitting stack, wherein the pixel defining film includes a first pixel defining film, a second pixel defining film on the first pixel defining film, and a third pixel defining film on the second pixel defining film, the second pixel defining film is recessed more inward than the third pixel defining film in the first opening, and lateral sides of the first pixel defining film, the second pixel defining film, and the third pixel defining film are at a same plane in the second opening, and a thickness of a portion of the first electrode overlapping the first opening is smaller than a thickness of a portion of the power connection electrode overlapping the second opening.

Aspects of the present disclosure provide a method for fabricating a display device in which openings of different shapes of a pixel defining film are formed in the same process without an additional mask.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

In the display device according to one or more embodiments, the pixel defining film may include an opening formed in a display area and having a tip structure, and an opening formed in a non-display area and having a smooth lateral side. Light emitting stacks of different adjacent sub-pixels may be separated by the opening in the display area, and the disconnection of an electrode layer may be prevented by the opening in the non-display area.

Additionally, the method for fabricating a display device according to one or more embodiments may shorten the fabrication processes by concurrently (e.g., simultaneously) forming the openings of different shapes without an additional mask.

However, effects, aspects, and features according to the embodiments of the present disclosure are not limited to those discussed above and various other effects, aspects, and features are incorporated herein.

At least some of the above and other features of the invention are set out in the claims.

### BRIEF DESCRIPTION OF THE DRAWINGS

The above and other aspects and features of embodiments of the present disclosure will become more apparent by describing in detail embodiments thereof with reference to the attached drawings, in which:
FIG. 1 is an exploded perspective view of a display device according to one or more embodiments;
FIG. 2 is a block diagram illustrating a display device according to one or more embodiments;
FIG. 3 is an equivalent circuit diagram of a sub-pixel according to one or more embodiments;
FIG. 4 is a diagram showing a display panel according to one or more embodiments;
FIG. 5 is a plan view showing first electrodes and emission areas of a plurality of pixels disposed in a display area of FIG. 4, and a pixel defining film;
FIG. 6 is a plan view showing first electrodes and emission areas of a plurality of sub-pixels, and a pixel defining film according to one or more embodiments;
FIG. 7 is a schematic cross-sectional view taken along the line A-A' of FIG. 5;
FIG. 8 is an enlarged view showing an area X of FIG. 4;
FIG. 9 is a schematic cross-sectional view taken along the line B-B' of FIG. 8;
FIG. 10 is a cross-sectional view showing a first electrode and a power connection electrode of a display device according to one or more embodiments;
FIG. 11 is a diagram showing in more detail a first electrode of a display device according to one or more embodiments;
FIGS. 12 - 18 are diagrams partially showing a fabrication process of a display device according to one or more embodiments;
FIG. 19 is a cross-sectional view showing a first electrode and a power connection electrode of a display device according to one or more embodiments;
FIG. 20 is a perspective view illustrating a head mounted display device according to one or more embodiments;
FIG. 21 is an exploded perspective view showing an example of the head mounted display device of FIG. 20; and
FIG. 22 is a perspective view illustrating a head mounted display device according to one or more embodiments.

### DETAILED DESCRIPTION

The present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that the present disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers may indicate the same or substantially similar components throughout the specification and drawings. In the attached figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the present disclosure may be combined partially or totally. As will be clearly appreciated by those skilled in the art, technically various interactions and operations are possible. Various embodiments can be practiced individually or in combination.

As used herein, a phrase "an element A on an element B" refers to that the element A may be disposed directly on the element B and/or the element A may be disposed indirectly on the element B via another element C. As used herein, "at least one of A, B and C" or "at least one of A, B, or C" may refer to A, B, C, AB, AC, BC, or ABC.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Hereinafter, embodiments will be described with reference to the accompanying drawings.

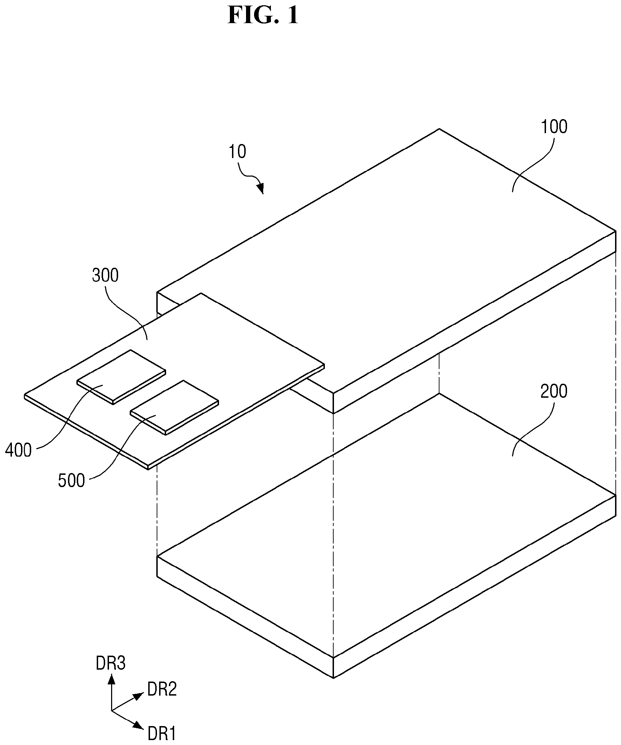

FIG. 1 is an exploded perspective view of a display device according to one or more embodiments.

Referring to FIG. 1, a display device 10 according to one or more embodiments is a device for displaying a moving image and/or a still image. The display device 10 according to one or more embodiments may be applied to portable electronic devices such as a mobile phone, a smartphone, a tablet personal computer, a mobile communication terminal, an electronic organizer, an electronic book, a portable multimedia player (PMP), a navigation system, an ultra mobile PC (UMPC), and/or the like. For example, the display device 10 may be applied as a display unit of a television, a laptop, a monitor, a billboard, or an Internet-of-Things (IoT) device. Alternatively, the display device 10 may be applied to a smart watch, a watch phone, a head mounted display device (HMD) for implementing virtual reality and augmented reality, and/or the like.

The display device 10 according to one or more embodiments includes a display panel 100, a heat dissipation layer 200, a circuit board 300, a timing control circuit 400, and a power supply circuit 500.

The display panel 100 may have a planar shape similar to a quadrilateral shape. For example, the display panel 100 may have a planar shape similar to a quadrilateral shape, having a short side of a first direction DR1 and a long side of a second direction DR2 intersecting the first direction DR1. In the display panel 100, a corner where a short side in the first direction DR1 and a long side in the second direction DR2 meet may be right-angled or rounded with a suitable curvature (e.g., a predetermined curvature). The planar shape of the display panel 100 is not limited to a quadrilateral shape, and may be a shape similar to another polygonal shape, a circular shape, and/or an elliptical shape. The planar shape of the display device 10 may conform to the planar shape of the display panel 100, but is not limited thereto.

The heat dissipation layer 200 may overlap the display panel 100 in a third direction DR3, which is the thickness direction of the display panel 100. The heat dissipation layer 200 may be disposed on one surface of the display panel 100, for example, on the rear surface thereof. The heat dissipation layer 200 serves to dissipate heat generated from the display panel 100. The heat dissipation layer 200 may include a metal layer having high thermal conductivity, such as graphite, silver (Ag), copper (Cu), or aluminum (Al).

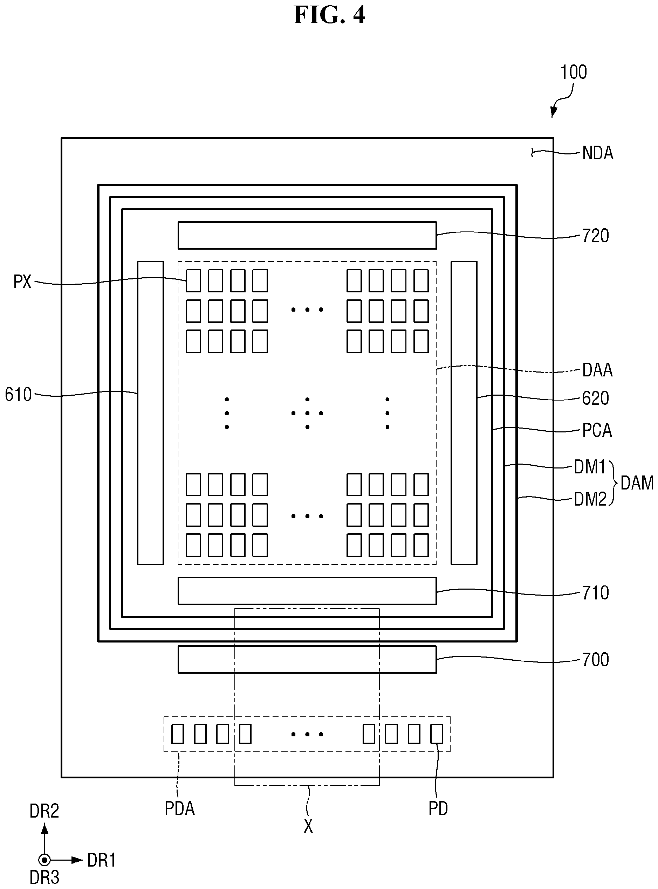

The circuit board 300 may be electrically connected to a plurality of pads PD (see FIG. 4) of a pad portion PDA (see FIG. 4) of the display panel 100 by using a conductive adhesive member such as an anisotropic conductive film. The circuit board 300 may be a flexible printed circuit board (FPCB) with a flexible material, and/or a flexible film. Although the circuit board 300 is illustrated in FIG. 1 as being unfolded, the circuit board 300 may be bent. In this case, one end of the circuit board 300 may be disposed on the rear surface of the display panel 100 and/or the rear surface of the heat dissipation layer 200. One end of the circuit board 300 may be an opposite end of the other end of the circuit board 300 connected to the plurality of pads PD (see FIG. 4) of the pad portion PDA (see FIG. 4) of the display panel 100 by using a conductive adhesive member.

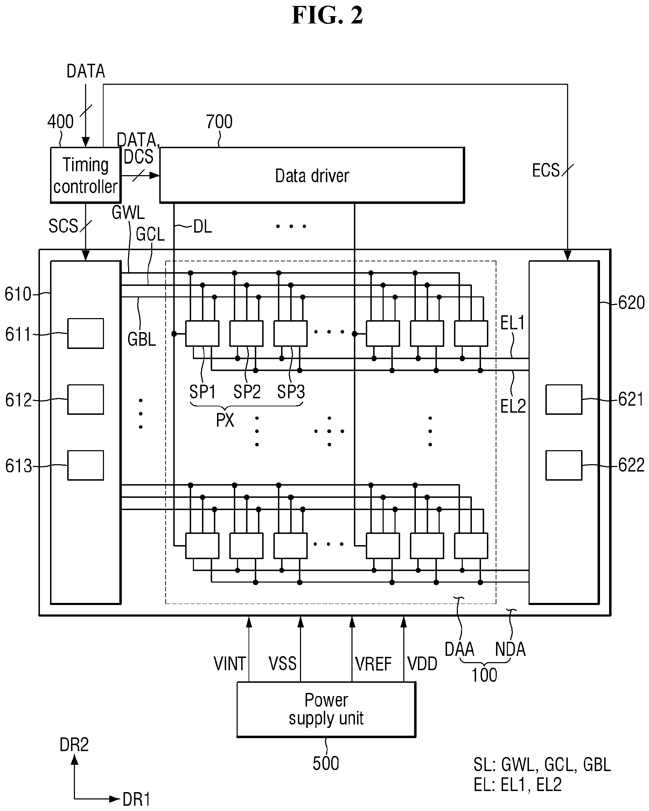

The timing control circuit 400 may receive digital video data and timing signals inputted from the outside. The timing control circuit 400 may generate a scan timing control signal SCS (see FIG. 2), an emission timing control signal ECS (see FIG. 2), and a data timing control signal DCS (see FIG. 2) for controlling the display panel 100 in response to the timing signals. The timing control circuit 400 may output the scan timing control signal SCS to a scan driver 610 (see FIG. 2), and output the emission timing control signal ECS to an emission driver 620 (see FIG. 2). The timing control circuit 400 may output the digital video data DATA and the data timing control signal DCS to a data driver 700 (see FIG. 2).

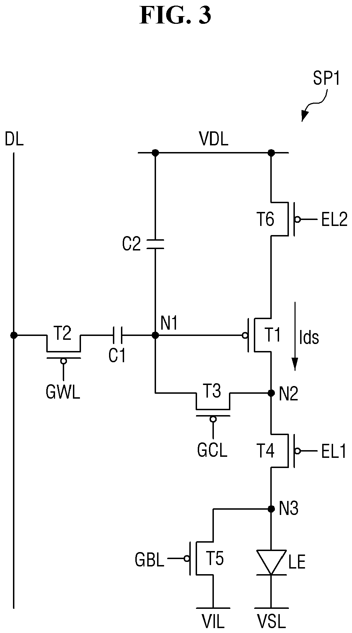

The power supply circuit 500 may generate a plurality of panel driving voltages according to a power voltage from the outside. For example, the power supply circuit 500 may generate a first driving voltage VSS (see FIG. 2), a second driving voltage VDD (see FIG. 2), a reference voltage VREF, and a third driving voltage VINT (see FIG. 2) and supply them to the display panel 100. The first driving voltage VSS, the second driving voltage VDD, the reference voltage VREF, and the third driving voltage VINT will be described later in conjunction with FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, digital video data DATA, and the data timing control signal DCS of the timing control circuit 400 may be supplied to the display panel 100 through the circuit board 300. Further, the first driving voltage VSS, the second driving voltage VDD, the reference voltage VREF, and the third driving voltage VINT of the power supply circuit 500 may be supplied to the display panel 100 through the circuit board 300.

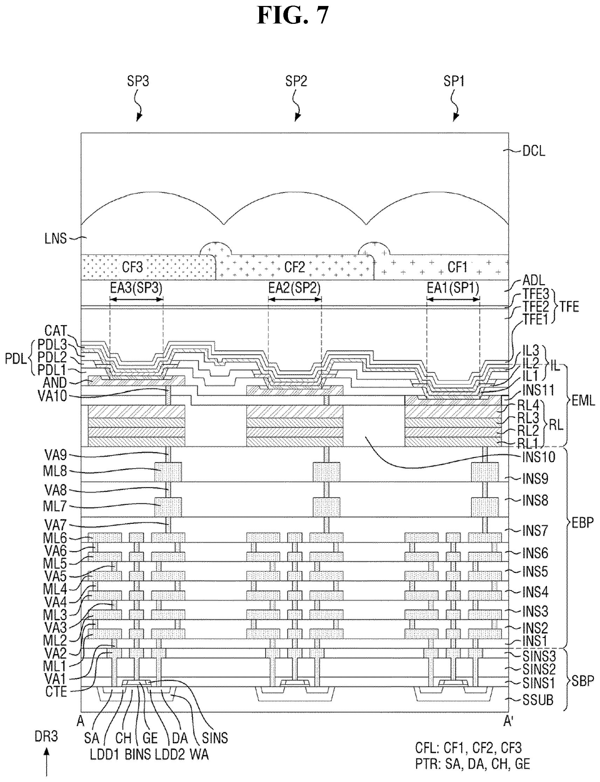

Alternatively, each of the timing control circuit 400 and the power supply circuit 500 may be disposed in a non-display area NDA (see FIG. 2) of the display panel 100, similarly to the scan driver 610, the emission driver 620, and the data driver 700. In this case, the timing control circuit 400 may include a plurality of timing transistors, and each power supply circuit 500 may include a plurality of power transistors. The plurality of timing transistors and the plurality of power transistors may be formed on the semiconductor substrate SSUB (see FIG. 7) through a semiconductor process. For example, the plurality of timing transistors and the plurality of power transistors may be formed of CMOS. Each of the timing control circuit 400 and the power supply circuit 500 may be disposed between the data driver 700 and the pad portion PDA (see FIG. 4).

FIG. 2 is a block diagram illustrating a display device according to one or more embodiments.

Referring to FIG. 2, the display panel 100 may include a display area DAA and the non-display area NDA disposed around the display area DAA along an edge or a periphery of the display area DAA. In the display area DAA, a plurality of pixels PX are disposed to emit light and/or display an image, and in the non-display area NDA, light may not be emitted and/or an image may not be displayed.

The display panel 100 may include the plurality of pixels PX, a plurality of scan lines SL, a plurality of emission control lines EL, and a plurality of data lines DL that are disposed in the display area DAA.

The plurality of pixels PX may be arranged along the first and second directions DR1 and DR2. The plurality of pixels PX may be arranged in a matrix in the display area DAA. For example, the plurality of pixels PX may be arranged along rows and columns of a matrix along the first direction DR1 and the second direction DR2. The plurality of scan lines SL and the plurality of emission control lines EL may extend in the first direction DR1, and may be disposed to be spaced (e.g., spaced apart) along the second direction DR2. The plurality of data lines DL may extend in the second direction DR2, may be disposed to be spaced (e.g., spaced apart) along the first direction DR1.

The plurality of scan lines SL may include a plurality of write scan lines GWL, a plurality of control scan lines GCL, and a plurality of bias scan lines GBL. The plurality of emission control lines EL include a plurality of first emission control lines EL1 and a plurality of second emission control lines EL2.

The plurality of pixels PX may include a plurality of sub-pixels SP1, SP2, and SP3. The plurality of sub-pixels SP1, SP2, and SP3 may include a plurality of pixel transistors as shown in FIG. 3. The plurality of pixel transistors may be formed through a semiconductor process to be disposed on the semiconductor substrate SSUB (see FIG. 7). For example, the plurality of pixel transistors may be formed of complementary metal oxide semiconductor (CMOS).

Each of the plurality of sub-pixels SP1, SP2, and SP3 may be connected to one write scan line GWL from among the plurality of write scan lines GWL, one control scan line GCL from among the plurality of control scan lines GCL, one bias scan line GBL from among the plurality of bias scan lines GBL, one first emission control line EL1 from among the plurality of first emission control lines EL1, one second emission control line EL2 from among the plurality of second emission control lines EL2, and one data line DL from among the plurality of data lines DL. Each of the plurality of sub-pixels SP1, SP2, and SP3 may receive a data voltage of the data line DL in response to a write scan signal of the write scan line GWL, and emit light from the light emitting element according to the data voltage.

The display panel 100 may include the scan driver 610, the emission driver 620, and the data driver 700 that are disposed in the non-display area NDA.

The scan driver 610 includes a plurality of scan transistors, and the emission driver 620 includes a plurality of light emitting transistors. The plurality of scan transistors and the plurality of light emitting transistors may be formed on the semiconductor substrate SSUB (see FIG. 7) through a semiconductor process. For example, the plurality of scan transistors and the plurality of light emitting transistors may be formed of CMOS. Although it is illustrated in FIG. 2 that the scan driver 610 is disposed on the left side of the display area DAA and the emission driver 620 is disposed on the right side of the display area DAA, the present disclosure is not limited thereto. For example, the scan driver 610 and the emission driver 620 may be disposed on both the left side and the right side of the display area DAA.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive the scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 includes a first emission control driver 621 and a second emission control driver 622. Each of the first emission control driver 621 and the second emission control driver 622 may receive the emission timing control signal ECS from the timing control circuit 400. The first emission control driver 621 may generate first emission control signals according to the emission timing control signal ECS and sequentially output them to the first emission control lines EL1. The second emission control driver 622 may generate second emission control signals according to the emission timing control signal ECS and sequentially output them to the second emission control lines EL2.

The data driver 700 may include a plurality of data transistors, and the plurality of data transistors may be formed on the semiconductor substrate SSUB (see FIG. 7) through a semiconductor process. For example, the plurality of data transistors may be formed of CMOS.

The data driver 700 may receive the digital video data DATA and the data timing control signal DCS from the timing control circuit 400. The data driver 700 converts the digital video data DATA into analog data voltages according to the data timing control signal DCS and outputs the analog data voltages to the data lines DL. In this case, the sub-pixels SP1, SP2, and SP3 are selected by the write scan signal of the scan driver 610, and data voltages may be supplied to the selected sub-pixels SP1, SP2, and SP3.

FIG. 3 is an equivalent circuit diagram of a sub-pixel according to one or more embodiments.

Referring to FIG. 3, the sub-pixel SP1 may be connected to the write scan line GWL, the control scan line GCL, the bias scan line GBL, the first emission control line EL1, the second emission control line EL2, and the data line DL. In addition, the sub-pixel SP may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The sub-pixel SP1 includes a plurality of transistors T1 to T6, a light emitting element LE, a first capacitor C1, and a second capacitor C2.

The light emitting element LE emits light in response to a driving current Ids flowing through the channel of a first transistor T1. The emission amount of the light emitting element LE may be proportional to the driving current Ids. The light emitting element LE may be disposed between a fourth transistor T4 and the first driving voltage line VSL. The first electrode of the light emitting element LE may be connected to the drain electrode of the fourth transistor T4, and the second electrode thereof may be connected to the first driving voltage line VSL. The first electrode of the light emitting element LE may be an anode electrode, and the second electrode of the light emitting element LE may be a cathode electrode. The light emitting element LE may be an organic light emitting diode (OLED) including a first electrode, a second electrode, and an organic light emitting layer disposed between the first electrode and the second electrode, but is not limited thereto. For example, the light emitting element LE may be an inorganic light emitting element including a first electrode, a second electrode, and an inorganic semiconductor disposed between the first electrode and the second electrode, in which case the light emitting element LE may be a micro light emitting diode.

The first transistor T1 may be a driving transistor that controls a source-drain current Ids (hereinafter referred to as a "driving current") flowing between the source electrode and the drain electrode of the first transistor T1 thereof according to a voltage applied to the gate electrode of the first transistor T1 thereof. The first transistor T1 includes a gate electrode connected to a first node N1, a source electrode connected to the drain electrode of a sixth transistor T6, and a drain electrode connected to a second node N2.

The second transistor T2 may be disposed between one electrode of the first capacitor C1 and the data line DL. The second transistor T2 is turned on by the write scan signal of the write scan line GWL to connect the one electrode of the first capacitor C1 to the data line DL. Accordingly, the data voltage of the data line DL may be applied to the one electrode of the first capacitor C1. The second transistor T2 includes a gate electrode connected to the write scan line GWL, a source electrode connected to the data line DL, and a drain electrode connected to the one electrode of the first capacitor C1.

A third transistor T3 may be disposed between the first node N1 and the second node N2. The third transistor T3 is turned on by the write control signal of the control scan line GCL to connect the first node N1 to the second node N2. For this reason, because the gate electrode and the source electrode of the first transistor T1 are connected, the first transistor T1 may operate like a diode (e.g., the first transistor T1 may be diode-connected). The third transistor T3 includes a gate electrode connected to the control scan line GCL, a source electrode connected to the second node N2, and a drain electrode connected to the first node N1.

The fourth transistor T4 may be connected between the second node N2 and a third node N3. The fourth transistor T4 is turned on by the first emission control signal of the first emission control line EL1 to connect the second node N2 to the third node N3. Accordingly, the driving current of the first transistor T1 may be supplied to the light emitting element LE. The fourth transistor T4 includes a gate electrode connected to the first emission control line EL1, a source electrode connected to the second node N2, and a drain electrode connected to the third node N3.

A fifth transistor T5 may be disposed between the third node N3 and the third driving voltage line VIL. The fifth transistor T5 is turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE. The fifth transistor T5 includes a gate electrode connected to the bias scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor C1 is formed between the first node N1 and the drain electrode of the second transistor T2. The first capacitor C1 includes one electrode connected to the drain electrode of the second transistor T2 and the other electrode connected to the first node N1.

The second capacitor C2 is formed between the gate electrode of the first transistor T1 and the second driving voltage line VDL. The second capacitor C2 includes one electrode connected to the gate electrode of the first transistor T1 or the first node N1 and the other electrode connected to the second driving voltage line VDL.

The first node N1 is a junction between the gate electrode of the first transistor T1, the drain electrode of the third transistor T3, the other electrode of the first capacitor C1, and the one electrode of the second capacitor C2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light emitting element LE.

Each of the first to sixth transistors T1 to T6 may be a metal-oxide-semiconductor field effect transistor (MOSFET). For example, each of the first to sixth transistors T1 to T6 may be a P-type MOSFET, but is not limited thereto. Each of the first to sixth transistors T1 to T6 may be an N-type MOSFET. Alternatively, some of the first to sixth transistors T1 to T6 may be P-type MOSFETs, and each of the remaining transistors may be an N-type MOSFETs.

Although FIG. 3 illustrates that the sub-pixel SP includes the six transistors T1 to T6 and the two capacitors C1 and C2, it should be noted that the equivalent circuit diagram of the sub-pixel SP is not limited to that shown in FIG. 3. For example, the number of the transistors and the number of the capacitors of the sub-pixel SP are not limited to the example shown in FIG. 3.

FIG. 4 is a diagram showing a display panel according to one or more embodiments.

Referring to FIG. 4, the display panel 100 according to one or more embodiments may include the plurality of pixels PX arranged in a matrix form in the display area DAA. For example, the plurality of pixels PX may be arranged along rows and columns of a matrix along the first direction DR1 and the second direction DR2. The display panel 100 may include the scan driver 610, the emission driver 620, the data driver 700, a first distribution circuit 710, a second distribution circuit 720, the pad portion PDA, a power connection portion PCA, and a dam structure DAM that are disposed in the non-display area NDA. In addition, in one or more embodiments, the display panel 100 may further include a static electricity protection portion, a moisture permeation prevention portion, and/or a crack prevention portion that are disposed outside the dam structure DAM.

The scan driver 610 may be disposed on the first side of the display area DAA, and the emission driver 620 may be disposed on the second side of the display area DAA. For example, the scan driver 610 may be disposed on one side of the display area DAA in the first direction DR1, and the emission driver 620 may be disposed on the other side of the display area DAA in the first direction DR1. That is, the scan driver 610 may be disposed on the left side of the display area DAA, and the emission driver 620 may be disposed on the right side of the display area DAA. However, the present disclosure is not limited thereto, and the scan driver 610 and the emission driver 620 may be disposed on both the first side and the second side of the display area DAA.

The pad portion PDA may include the plurality of pads PD connected to pads or bumps of the circuit board 300 through a conductive adhesive member. The pad portion PDA may be disposed on the third side of the display area DAA. For example, the pad portion PDA may be disposed on one side of the display area DAA in the second direction DR2. That is, the pad portion PDA may be disposed on the lower side of the display area DAA. The pad portion PDA may be disposed outside the data driver 700 in the second direction DR2. That is, the pad portion PDA may be disposed closer to the edge of the display panel 100 than the data driver 700.

In one or more embodiments, the display panel 100 may further include inspection pads to check whether the display panel 100 operates normally. The inspection pads may be connected to a jig and/or a probe pin during an inspection process, or may be connected to a circuit board for inspection. The circuit board for inspection may be a printed circuit board (PCB) made of a rigid material and/or a flexible printed circuit board (FPCB) made of a flexible material.

The first distribution circuit 710 distributes data voltages applied through the pad portion PDA to the plurality of data lines DL. For example, the first distribution circuit 710 may distribute the data voltages applied through one pad PD of the pad portion PDA to the P (P is a positive integer of 2 or more) data lines DL, and as a result, the number of the plurality of pads PD may be reduced. The first distribution circuit 710 may be disposed on the third side of the display area DAA of the display panel 100. For example, the first distribution circuit 710 may be disposed on one side of the display area DAA in the second direction DR2. That is, the first distribution circuit 710 may be disposed on the lower side of the display area DAA.

The second distribution circuit 720 distributes signals applied through the pad portion PDA to the scan driver 610, the emission driver 620, and the data lines DL. The second distribution circuit 720 may be configured to inspect the operation of each of the pixels PX in the display area DAA. The second distribution circuit 720 may be disposed on the fourth side of the display area DAA of the display panel 100. For example, the second distribution circuit 720 may be disposed on the other side of the display area DAA in the second direction DR2. That is, the second distribution circuit 720 may be disposed on the upper side of the display area DAA. However, the second distribution circuit 720 may be omitted.

The power connection portion PCA refers to the area in which the second electrode of the light emitting element LE (see FIG. 3) and a power connection electrode to which the first driving voltage VSS is applied are connected, to apply the first driving voltage VSS to the second electrode of the light emitting element LE (see FIG. 3).

The power connection portion PCA may be disposed to be around (e.g., to surround) the display area DAA. In addition, the power connection portion PCA may be disposed outside the scan driver 610, the emission driver 620, the first distribution circuit 710, and the second distribution circuit 720. For example, the power connection portion PCA may be disposed closer to the edge of the display panel 100 than the scan driver 610, the emission driver 620, the first distribution circuit 710, and the second distribution circuit 720. The power connection portion PCA may be disposed to be around (e.g., to surround) the scan driver 610, the emission driver 620, the first distribution circuit 710, and the second distribution circuit 720. However, the present disclosure is not limited thereto, and the power connection portion PCA may overlap at least one of the scan driver 610, the emission driver 620, the first distribution circuit 710, or the second distribution circuit 720 in the third direction DR3.

The dam structure DAM may be a structure for preventing an organic encapsulation layer TFE2 of an encapsulation layer TFE (see FIG. 7) for encapsulating the light emitting elements LE (see FIG. 3) from overflowing to the pad portion PDA.

The dam structure DAM may be disposed to be around (e.g., to surround) the display area DAA. In addition, the dam structure DAM may be disposed outside the scan driver 610, the emission driver 620, the first distribution circuit 710, and the second distribution circuit 720. For example, the dam structure DAM may be disposed closer to the edge of the display panel 100 than the scan driver 610, the emission driver 620, the first distribution circuit 710, and the second distribution circuit 720. The dam structure DAM may be disposed to be around (e.g., to surround) the scan driver 610, the emission driver 620, the first distribution circuit 710, and the second distribution circuit 720. However, the present disclosure is not limited thereto, and the dam structure DAM may overlap at least one of the scan driver 610, the emission driver 620, the first distribution circuit 710, or the second distribution circuit 720 in the third direction DR3.

In addition, the dam structure DAM may be disposed outside the power connection portion PCA. For example, the dam structure DAM may be disposed closer to the edge of the display panel 100 than the power connection portion PCA. The dam structure DAM may be disposed to be around (e.g., to surround) the power connection portion PCA.

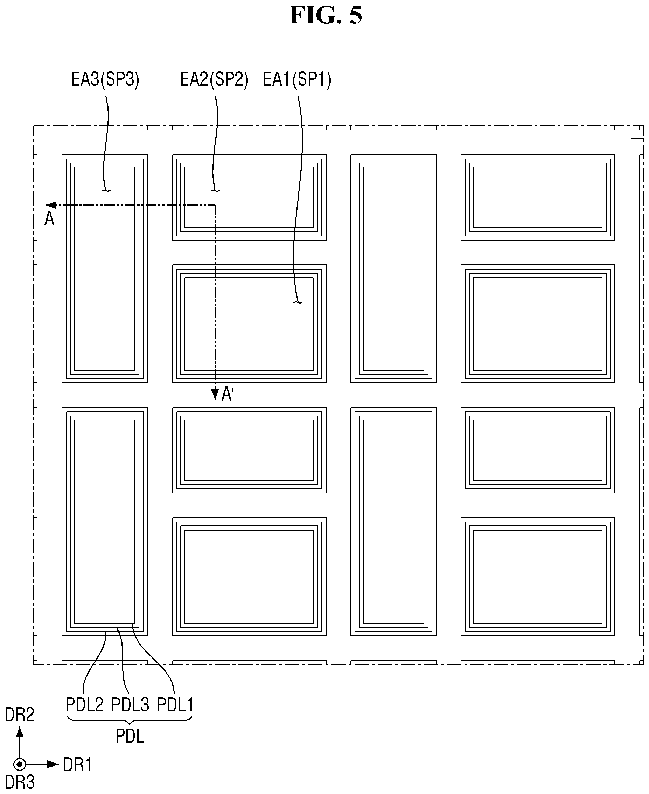

FIG. 5 is a plan view showing first electrodes and emission areas of a plurality of pixels disposed in a display area of FIG. 4, and a pixel defining film.

Referring to FIG. 5, each of the plurality of pixels PX may include a first sub-pixel SP1, a second sub-pixel SP2, and a third sub-pixel SP3. The first to third sub-pixels SP1, SP2, and SP3 may include emission areas EA1, EA2, and EA3, respectively. For example, the first sub-pixel SP1 may include the first emission area EA1, the second sub-pixel SP2 may include the second emission area EA2, and the third sub-pixel SP3 may include the third emission area EA3.

Each of the first emission area EA1, the second emission area EA2, and the third emission area EA3 may be an area defined by a pixel defining film PDL. For example, each of the first emission area EA1, the second emission area EA2, and the third emission area EA3 may be an area defined by a first pixel defining film PDL1.

The length of the third emission area EA3 in the first direction DR1 may be smaller than the length of the first emission area EA1 in the first direction DR1, and may be smaller than the length of the second emission area EA2 in the first direction DR1. The length of the first emission area EA1 in the first direction DR1 and the length of the second emission area EA2 in the first direction DR1 may be substantially the same.

In each of the plurality of pixels PX, the first emission area EA1 and the second emission area EA2 may be adjacent to each other in the second direction DR2. Further, the first emission area EA1 and the third emission area EA3 may be adjacent to each other in the first direction DR1. Further, the second emission area EA2 and the third emission area EA3 may be adjacent to each other in the first direction DR1. The area of the first emission area EA1, the area of the second emission area EA2, and the area of the third emission area EA3 may be different.

The first emission area EA1 may emit light of a first color, the second emission area EA2 may emit light of a second color, and the third emission area EA3 may emit light of a third color. Here, the light of the first color may be light of a red wavelength band, the light of the second color may be light of a green wavelength band, and the light of the third color may be light of a blue wavelength band. For example, the blue wavelength band may be a wavelength band of light whose main peak wavelength is in the range of about 370 nm to about 460 nm, the green wavelength band may be a wavelength band of light whose main peak wavelength is in the range of about 480 nm to about 560 nm, and the red wavelength band may be a wavelength band of light whose main peak wavelength is in the range of about 600 nm to about 750 nm.

A first electrode AND (e.g., see FIG. 7) of the light emitting element LE may have a rectangular shape in a plan view. The planar shape of the first electrode AND of the light emitting element LE may be different in the first sub-pixel SP1, the second sub-pixel SP2, and the third sub-pixel SP3. For example, the first electrode AND of the first sub-pixel SP1 and the first electrode AND of the second sub-pixel SP2 may have a rectangular planar shape having a long side in the first direction DR1 and a short side in the second direction DR2. The first electrode AND of the third sub-pixel SP3 may have a rectangular shape, in a plan view, having a short side in the first direction DR1 and a long side in the second direction DR2. The length of the first electrode AND of the third sub-pixel SP3 in the first direction DR1 may be shorter than the length of the first electrode AND of each of the first sub-pixel SP1 and the second sub-pixel SP2 in the second direction DR2. The length of the first electrode AND of the first sub-pixel SP1 in the second direction DR2 may be longer than the length of the first electrode AND of the second sub-pixel SP2 in the second direction DR2.

In one or more embodiments, the first electrode AND of the light emitting element LE may be connected to a reflective electrode layer RL (see FIG. 7) through a tenth via VA10. In one or more embodiments, the tenth via VA10 may overlap the first pixel defining film PDL1, a second pixel defining film PDL2, and a third pixel defining film PDL3 in the third direction DR3.

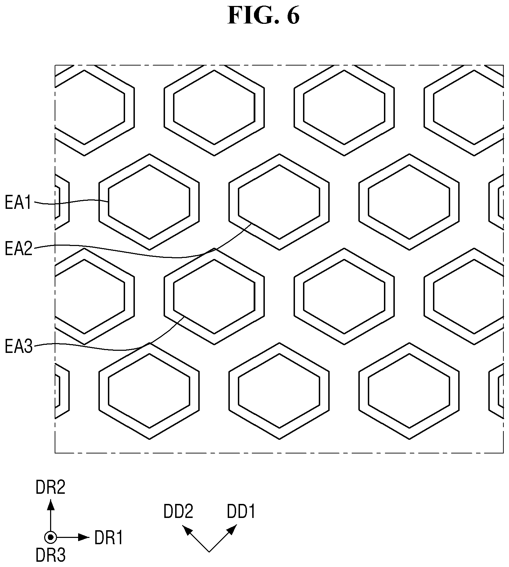

FIG. 6 is a plan view showing first electrodes and emission areas of a plurality of sub-pixels, and a pixel defining film according to one or more embodiments.

Because the embodiment of FIG. 6 is substantially the same as the embodiment of FIG. 5 except that the planar shapes of the first emission area EA1, the second emission area EA2, and the third emission area EA3 are different from those of the embodiment of FIG. 5, description overlapping with the embodiment of FIG. 5 will be omitted.

Referring to FIG. 6, the first emission area EA1, the second emission area EA2, and the third emission area EA3 may be disposed in a hexagonal structure having a hexagonal shape in a plan view. In this case, the first emission area EA1 and the second emission area EA2 may be adjacent to each other in the first direction DR1, but the second emission area EA2 and the third emission area EA3 may be adjacent to each other in a first diagonal direction DD1, and the first emission area EA1 and the third emission area EA3 may be adjacent to each other in a second diagonal direction DD2. The first diagonal direction DD1 may be a direction between the first direction DR1 and the second direction DR2, and may refer to a direction inclined by 45 degrees with respect to the first direction DR1 and the second direction DR2, and the second diagonal direction DD2 may be a direction perpendicular to the first diagonal direction DD1.

Although it is illustrated in FIGS. 5 and 6 that each of the plurality of pixels PX includes the three emission areas EA1, EA2, and EA3, the present disclosure is not limited thereto. That is, each of the plurality of pixels PX may include four emission areas.

In addition, the disposition of the emission areas EA1, EA2, and EA3 of the plurality of pixels PX is not limited to that illustrated in FIGS. 5 and 6. For example, the emission areas of the plurality of pixels PX may be disposed in a stripe structure in which the emission areas are arranged along the first direction DR1, a PENTILE^{®} structure in which the emission areas are arranged in a diamond shape, and/or the like. The PENTILE^{®} pixel arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea.

FIG. 7 is a schematic cross-sectional view taken along the line A-A' of FIG. 5.

Referring to FIG. 7, the display panel 100 may include a semiconductor backplane SBP, a light emitting element backplane EBP, a display element layer EML, the encapsulation layer TFE, an adhesive layer ADL, a color filter layer CFL, a lens array layer LNS, and a cover layer DCL. In one or more embodiments, the display panel 100 may further include a polarizing plate disposed on the cover layer DCL.

The semiconductor backplane SBP includes the semiconductor substrate SSUB including a plurality of pixel transistors PTR, a plurality of semiconductor insulating films covering the plurality of pixel transistors PTR, and a plurality of contact terminals CTE electrically connected to the plurality of pixel transistors PTR, respectively. The plurality of pixel transistors PTR may be the first to sixth transistors T1 to T6 described with reference to FIG. 3.

The semiconductor substrate SSUB may be a silicon substrate, a germanium substrate, and/or a silicon-germanium substrate. The semiconductor substrate SSUB may be a substrate doped with a first type impurity. A plurality of well regions WA may be disposed on the top surface of the semiconductor substrate SSUB. The plurality of well regions WA may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

Each of the plurality of well regions WA includes a source region SA corresponding to the source electrode of the pixel transistor PTR, a drain region DA corresponding to the drain electrode thereof, and a channel region CH disposed between the source region SA and the drain region DA.

A lower insulating film BINS may be disposed between a gate electrode GE and the well region WA. A side insulating film SINS may be disposed on the side surface of the gate electrode GE. The side insulating film SINS may be disposed on the lower insulating film BINS.

Each of the source region SA and the drain region DA may be a region doped with the first type impurity. The gate electrode GE of the pixel transistor PTR may overlap the well region WA in the third direction DR3. The channel region CH may overlap the gate electrode GE in the third direction DR3. The source region SA may be disposed on one side of the gate electrode GE, and the drain region SA may be disposed on the other side of the gate electrode GE.

Each of the plurality of well regions WA further includes a first low-concentration impurity region LDD1 disposed between the channel region CH and the source region SA, and a second low-concentration impurity region LDD2 disposed between the channel region CH and the drain region DA. The first low-concentration impurity region LDD1 may be a region having a lower impurity concentration than the source region SA due to the lower insulating film BINS. The second low-concentration impurity region LDD2 may be a region having a lower impurity concentration than the drain region DA due to the lower insulating film BINS. The distance between the source region SA and the drain region DA may increase due to the presence of the first low-concentration impurity region LDD1 and the second low-concentration impurity region LDD2. Therefore, the length of the channel region CH of each of the pixel transistors PTR may increase, so that punch-through and hot carrier phenomena that might be caused by a short channel may be reduced or prevented.

A first semiconductor insulating film SINS1 may be disposed on the semiconductor substrate SSUB to cover the gate electrode GE. The first semiconductor insulating film SINS1 may be formed of silicon carbonitride (SiCN) and/or a silicon oxide (SiOₓ)-based inorganic film, but is not limited thereto.

A second semiconductor insulating film SINS2 may be disposed on the first semiconductor insulating film SINS1. The second semiconductor insulating film SINS2 may be formed of a silicon oxide (SiOₓ)-based inorganic film, but is not limited thereto.

The plurality of contact terminals CTE may be disposed on the second semiconductor insulating film SINS2. Each of the plurality of contact terminals CTE may be connected to one of the gate electrode GE, the source region SA, and the drain region DA of each of the pixel transistors PTR through holes penetrating the first semiconductor insulating film SINS1 and the second semiconductor insulating film SINS2. The plurality of contact terminals CTE may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them.

A third semiconductor insulating film SINS3 may be disposed on the second semiconductor insulating film SINS2. The third semiconductor insulating film SINS3 may also be disposed on a side surface of each of the portions of the plurality of contact terminals CTE disposed on the second semiconductor insulating film SINS2. The top surface of each of the plurality of contact terminals CTE may be exposed without being covered by the third semiconductor insulating film SINS3. The third semiconductor insulating film SINS3 may be formed of a silicon oxide (SiOₓ)-based inorganic film, but is not limited thereto.

The semiconductor substrate SSUB may be replaced with a glass substrate and/or a polymer resin substrate such as polyimide. In this case, thin film transistors may be disposed on the glass substrate and/or the polymer resin substrate. The glass substrate may be a rigid substrate that does not bend, and the polymer resin substrate may be a flexible substrate that can be bent and/or curved.

The light emitting element backplane EBP includes first to eighth metal layers ML1 to ML8, and a plurality of vias VA1 to VA10. In addition, the light emitting element backplane EBP includes a plurality of interlayer insulating layers INS1 to INS9 disposed between the first to eighth metal layers ML1 to ML8.

The first to eighth metal layers ML1 to ML8 may connect the plurality of contact terminals CTE exposed from the semiconductor backplane SBP to form a circuit of the sub-pixel SP shown in FIG. 3. The first to sixth transistors T1 to T6 may be formed in the semiconductor backplane SBP, and the connection of the first to sixth transistors T1 to T6 and the first and second capacitors C1 and C2 may be accomplished through the first to eighth metal layers ML1 to ML8. In addition, the connection between the drain region corresponding to the drain electrode of the fourth transistor T4, the source region corresponding to the source electrode of the fifth transistor T5, and the first electrode of the light emitting element LE may also be accomplished through the first to eighth metal layers ML1 to ML8.

The first interlayer insulating layer INS1 may be disposed on the semiconductor backplane SBP. Each of the first vias VA1 may penetrate the first interlayer insulating layer INS1 to be connected to the contact terminal CTE exposed from the semiconductor backplane SBP. Each of the first metal layers ML1 may be disposed on the first interlayer insulating layer INS1 and may be connected to the first via VA1.

A second interlayer insulating layer INS2 may be disposed on the first interlayer insulating layer INS1 and the first metal layers ML1. Each of the second vias VA2 may penetrate the second interlayer insulating layer INS2 and may be connected to the exposed first metal layer ML1. Each of the second metal layers ML2 may be disposed on the second interlayer insulating layer INS2 and may be connected to the second via VA2.

A third interlayer insulating layer INS3 may be disposed on the second interlayer insulating layer INS2 and the second metal layers ML2. Each of the third vias VA3 may penetrate the third interlayer insulating layer INS3 and may be connected to the exposed second metal layer ML2. Each of the third metal layers ML3 may be disposed on the third interlayer insulating layer INS3 and may be connected to the third via VA3.

A fourth interlayer insulating layer INS4 may be disposed on the third interlayer insulating layer INS3 and the third metal layers ML3. Each of the fourth vias VA4 may penetrate the fourth interlayer insulating layer INS4 and may be connected to the exposed third metal layer ML3. Each of the fourth metal layers ML4 may be disposed on the fourth interlayer insulating layer INS4 and may be connected to the fourth via VA4.

A fifth interlayer insulating layer INS5 may be disposed on the fourth interlayer insulating layer INS4 and the fourth metal layers ML4. Each of the fifth vias VA5 may penetrate the fifth interlayer insulating layer INS5 and may be connected to the exposed fourth metal layer ML4. Each of the fifth metal layers ML5 may be disposed on the fifth interlayer insulating layer INS5 and may be connected to the fifth via VA5.

A sixth interlayer insulating layer INS6 may be disposed on the fifth interlayer insulating layer INS5 and the fifth metal layers ML5. Each of the sixth vias VA6 may penetrate the sixth interlayer insulating layer INS6 and may be connected to the exposed fifth metal layer ML5. Each of the sixth metal layers ML6 may be disposed on the sixth interlayer insulating layer INS6 and may be connected to the sixth via VA6.

A seventh interlayer insulating layer INS7 may be disposed on the sixth interlayer insulating layer INS6 and the sixth metal layers ML6. Each of the seventh vias VA7 may penetrate the seventh interlayer insulating layer INS7 and may be connected to the exposed sixth metal layer ML6. Each of the seventh metal layers ML7 may be disposed on the seventh interlayer insulating layer INS7 and may be connected to the seventh via VA7.

An eighth interlayer insulating layer INS8 may be disposed on the seventh interlayer insulating layer INS7 and the seventh metal layers ML7. Each of the eighth vias VA8 may penetrate the eighth interlayer insulating layer INS8 and may be connected to the exposed seventh metal layer ML7. Each of the eighth metal layers ML8 may be disposed on the eighth interlayer insulating layer INS8 and may be connected to the eighth via VA8.

The first to eighth metal layers ML1 to ML8 and the first to eighth vias VA1 to VA8 may be formed of substantially the same material. The first to eighth metal layers ML1 to ML8 and the first to eighth vias VA1 to VA8 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. The first to eighth vias VA1 to VA8 may be made of substantially the same material. First to eighth interlayer insulating layers INS1 to INS8 may be formed of a silicon oxide (SiOₓ)-based inorganic film, but are not limited thereto.

In one or more embodiments, the thicknesses of the first metal layer ML1, the second metal layer ML2, the third metal layer ML3, the fourth metal layer ML4, the fifth metal layer ML5, and the sixth metal layer ML6 may be greater than the thicknesses of the first via VA1, the second via VA2, the third via VA3, the fourth via VA4, the fifth via VA5, and the sixth via VA6, respectively. In one or more embodiments, the thickness of each of the second metal layer ML2, the third metal layer ML3, the fourth metal layer ML4, the fifth metal layer ML5, and the sixth metal layer ML6 may be greater than the thickness of the first metal layer ML1. In one or more embodiments, the thickness of the second metal layer ML2, the thickness of the third metal layer ML3, the thickness of the fourth metal layer ML4, the thickness of the fifth metal layer ML5, and the thickness of the sixth metal layer ML6 may be substantially the same. For example, the thickness of the first metal layer ML1 may be approximately 1360 Å, the thickness of each of the second metal layer ML2, the third metal layer ML3, the fourth metal layer ML4, the fifth metal layer ML5, and the sixth metal layer ML6 may be approximately 1440 Å, and the thickness of each of the first via VA1, the second via VA2, the third via VA3, the fourth via VA4, the fifth via VA5, and the sixth via VA6 may be approximately 1150 Å.

The thickness of each of the seventh metal layer ML7 and the eighth metal layer ML8 may be greater than the thickness of the first metal layer ML1, the thickness of the second metal layer ML2, the thickness of the third metal layer ML3, the thickness of the fourth metal layer ML4, the thickness of the fifth metal layer ML5, and the thickness of the sixth metal layer ML6. The thickness of each of the seventh metal layer ML7 and the thickness of the eighth metal layer ML8 may be greater than the thickness of the seventh via VA7 and the thickness of the eighth via VA8. The thickness of each of the seventh via VA7 and the eighth via VA8 may be greater than the thickness of the first via VA1, the thickness of the second via VA2, the thickness of the third via VA3, the thickness of the fourth via VA4, the thickness of the fifth via VA5, and the thickness of the sixth via VA6. The thickness of the seventh metal layer ML7 and the thickness of the eighth metal layer ML8 may be substantially the same. For example, the thickness of each of the seventh metal layer ML7 and the eighth metal layer ML8 may be approximately 9000 Å. The thickness of each of the seventh via VA7 and the eighth via VA8 may be approximately 6000 Å.

A ninth interlayer insulating layer INS9 may be disposed on the eighth interlayer insulating layer INS8 and the eighth metal layers ML8. The ninth interlayer insulating layer INS9 may be formed of a silicon oxide (SiOₓ)-based inorganic film, but is not limited thereto.

Each of the ninth vias VA9 may penetrate the ninth interlayer insulating layer INS9 and may be connected to the exposed eighth metal layer ML8. The ninth vias VA9 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. The thickness of the ninth via VA9 may be approximately 16500 Å.

The display element layer EML may be disposed on the light emitting element backplane EBP and the ninth interlayer insulating layer INS9. The display element layer EML may include light emitting elements each including a reflective electrode layer RL, a tenth interlayer insulating layer INS10, an eleventh interlayer insulating layer INS11, a tenth via VA10, the first electrode AND, a light emitting stack IL, and a second electrode CAT, and pixel defining films PDL.

The reflective electrode layer RL may be disposed on the ninth interlayer insulating layer INS9. The reflective electrode layer RL may include at least one of the reflective electrodes RL1, RL2, RL3, and/or RL4. For example, the reflective electrode RL may include the first to fourth reflective electrodes RL1, RL2, RL3, and RL4 as shown in FIG. 7.

Each of the first reflective electrodes RL1 may be disposed on the ninth interlayer insulating layer INS9, and may be connected to the ninth via VA9. The first reflective electrodes RL1 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. For example, the first reflective electrodes RL1 may include titanium nitride (TiN).

Each of the second reflective electrodes RL2 may be disposed on the first reflective electrode RL1. The second reflective electrodes RL2 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. For example, the second reflective electrodes RL2 may include aluminum (Al).

Each of the third reflective electrodes RL3 may be disposed on the second reflective electrode RL2. The third reflective electrodes RL3 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. For example, the third reflective electrodes RL3 may include titanium nitride (TiN).

The fourth reflective electrodes RL4 may be respectively disposed on the third reflective electrodes RL3. The fourth reflective electrodes RL4 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. For example, the fourth reflective electrodes RL4 may include titanium (Ti).

Because the second reflective electrode RL2 is an electrode that substantially reflects light from the light emitting elements LE, in one or more embodiments, the thickness of the second reflective electrode RL2 may be greater than the thickness of each of the first reflective electrode RL1, the third reflective electrode RL3, and the fourth reflective electrode RL4. For example, in one or more embodiments, the thickness of each of the first reflective electrode RL1, the third reflective electrode RL3, and the fourth reflective electrode RL4 may be approximately 100 Å, and the thickness of the second reflective electrode RL2 may be 850 Å. However, in one or more other embodiments, the thickness of the second reflective electrode RL2 may be substantially the same as the thickness of each of the first reflective electrode RL1, the third reflective electrode RL3, and the fourth reflective electrode RL4.

The tenth interlayer insulating layer INS10 may be disposed on the ninth interlayer insulating layer INS9. The tenth interlayer insulating layer INS10 may be disposed between the reflective electrode layers RL adjacent to each other. The tenth interlayer insulating layer INS10 may be disposed on the reflective electrode layer RL in the third sub-pixel SP3. The tenth interlayer insulating layer INS10 may be formed of a silicon oxide (SiOₓ)-based inorganic film, but is not limited thereto.

The eleventh interlayer insulating layer INS11 may be disposed on the tenth interlayer insulating layer INS10 and the reflective electrode layer RL in the second sub-pixel SP2 and the third sub-pixel SP3. The eleventh interlayer insulating layer INS11 may be formed of a silicon oxide (SiOₓ)-based inorganic film, but is not limited thereto.

In at least one of the first sub-pixel SP1, the second sub-pixel SP2, or the third sub-pixel SP3, the tenth interlayer insulating layer INS10 and the eleventh interlayer insulating layer INS11 may not be disposed under the first electrode AND in consideration of the resonance distance of the light emitted from the light emitting elements.

For example, the first electrode AND of the first sub-pixel SP1 may be directly disposed on the fourth reflective electrode RL4, and the first electrode AND of the first sub-pixel SP1 may not overlap the tenth interlayer insulating layer INS10 and the eleventh interlayer insulating layer INS11. The first electrode AND of the second sub-pixel SP2 may be disposed on the eleventh interlayer insulating layer INS11, and the eleventh interlayer insulating layer INS11 may be directly disposed on the fourth reflective electrode RL4. That is, the first electrode AND of the second sub-pixel SP2 may not overlap the tenth interlayer insulating layer INS10. The first electrode AND of the third sub-pixel SP3 may be disposed on the eleventh interlayer insulating layer INS11, and may overlap the tenth interlayer insulating layer INS10.

In one or more embodiments, the distance between the first electrode AND and the reflective electrode layer RL may be different in the first sub-pixel SP1, the second sub-pixel SP2, and the third sub-pixel SP3. In order to adjust the distance from the reflective electrode layer RL to a second electrode CAT according to the main wavelength of the light emitted from each of the first sub-pixel SP1, the second sub-pixel SP2, and the third sub-pixel SP3, the presence or absence of the tenth interlayer insulating layer INS10 and the eleventh interlayer insulating layer INS11 may be set in each of the first sub-pixel SP1, the second sub-pixel SP2, and the third sub-pixel SP3. For example, in FIG. 7, the distance between the first electrode AND and the reflective electrode layer RL in the third sub-pixel SP3 may be greater than the distance between the first electrode AND and the reflective electrode layer RL in the second sub-pixel SP2 and the distance between the first electrode AND and the reflective electrode layer RL in the first sub-pixel SP1, and the distance between the first electrode AND and the reflective electrode layer RL in the second sub-pixel SP2 may be greater than the distance between the first electrode AND and the reflective electrode layer RL in the first sub-pixel SP1. However, the present disclosure is not limited thereto. The distance between the first electrode AND and the reflective electrode layer RL in each of the sub-pixels SP1, SP2, and SP3 may be variously modified and designed.

In addition, although the tenth interlayer insulating layer INS10 and the eleventh interlayer insulating layer INS11 are illustrated in the drawing, a twelfth interlayer insulating layer may be further disposed under the first electrode AND of the sub-pixel SP (SP1, SP2, SP3). In this case, the eleventh interlayer insulating layer INS11 and a twelfth interlayer insulating layer INS12 may be disposed under the first electrode AND of the second sub-pixel SP2, and the tenth interlayer insulating layer INS10, the eleventh interlayer insulating layer INS11, and the twelfth interlayer insulating layer INS12 may be disposed under the first electrode AND of the third sub-pixel SP3. Alternatively, the eleventh interlayer insulating layer INS11 may be omitted.

Each of the tenth vias VA10 may penetrate the tenth interlayer insulating layer INS10 and/or the eleventh interlayer insulating layer INS11 in the second sub-pixel SP2 and the third sub-pixel SP3 and may be connected to the exposed fourth reflective electrode RL4. The tenth vias VA10 may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. The thickness of the tenth via VA10 in the second sub-pixel SP2 may be smaller than the thickness of the tenth via VA10 in the third sub-pixel SP3.

In one or more embodiments, the first electrode AND of each of the light emitting elements may be disposed on the tenth interlayer insulating layer INS10 or the eleventh interlayer insulating layer INS11, and may be connected to the tenth via VA10. The first electrode AND of each of the light emitting elements LE may be connected to the drain region DA or source region SA of the pixel transistor through the tenth via VA10, the first to fourth reflective electrodes RL1 to RL4, the first to ninth vias VA1 to VA9, the first to eighth metal layers ML1 to ML8, and the contact terminal CTE. The first electrode AND of each of the light emitting elements LE may be formed of copper (Cu), aluminum (Al), tungsten (W), molybdenum (Mo), chromium (Cr), gold (Au), titanium (Ti), nickel (Ni), and/or neodymium (Nd), and/or an alloy including one or more of them. For example, the first electrode AND of each of the light emitting elements LE may be titanium nitride (TiN).

The pixel defining film PDL may be disposed on a part of the first electrode AND of each of the light emitting elements. The pixel defining film PDL may cover an edge of the first electrode AND. The pixel defining film PDL may partition the first emission areas EA1, the second emission areas EA2, and the third emission areas EA3.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining film PDL may include first to third pixel defining films PDL1, PDL2, and PDL3. The first pixel defining film PDL1 may be disposed on the edge of the first electrode AND of each of the light emitting elements, the second pixel defining film PDL2 may be disposed on the first pixel defining film PDL1, and the third pixel defining film PDL3 may be disposed on the second pixel defining film PDL2. The first pixel defining film PDL1, the second pixel defining film PDL2, and the third pixel defining film PDL3 may be formed of a silicon oxide (SiOₓ) and/or silicon nitride (SiNₓ)-based inorganic film, but are not limited thereto. The first pixel defining film PDL1, the second pixel defining film PDL2, and the third pixel defining film PDL3 may each have a thickness of about 500 Å.

According to one or more embodiments, the pixel defining film PDL disposed in the display area DAA is configured such that the second pixel defining film PDL2 may be recessed more inward than the first pixel defining film PDL1 and the third pixel defining film PDL3 at the openings forming the emission areas EA1, EA2, and EA3. The first pixel defining film PDL1 and the third pixel defining film PDL3 of the pixel defining film PDL may protrude further into the opening from the lower portion and the upper portion of the second pixel defining film PDL2. The third pixel defining film PDL3 that is the uppermost layer of the pixel defining film PDL may include a tip that protrudes more than the lower layer thereof. As the third pixel defining film PDL3 has a shape that protrudes from the inner sidewall of the opening more than the second pixel defining film PDL2, an undercut structure of the second pixel defining film PDL2 may be formed below the tip of the third pixel defining film PDL3.

A portion of the top surface of the first electrode AND overlapping the first pixel defining film PDL1 may be partially recessed. In the process of forming the opening of the pixel defining film PDL, a portion of the top surface of the first electrode AND is recessed, and the first pixel defining film PDL1 may form a tip structure. A part of the top surface of the first electrode AND may be spaced (e.g., spaced apart) from the first pixel defining film PDL1, but an edge portion may be directly in contact with the first pixel defining film PDL1.

The light emitting stack IL may include a plurality of intermediate layers. It is illustrated in FIG. 7 that the light emitting stack IL has a three-tandem structure including a first light emitting stack IL1, a second light emitting stack IL2, and a third light emitting stack IL3, but the present disclosure is not limited thereto. For example, the light emitting stack IL may have a two-tandem structure including two intermediate layers.

In the three-tandem structure, the light emitting stack IL may have a tandem structure including the plurality of light emitting stacks IL1, IL2, and IL3 that emit different lights. For example, the light emitting stack IL may include the first light emitting stack IL1 that emits light of the first color, the second light emitting stack IL2 that emits light of the third color, and the third light emitting stack IL3 that emits light of the second color. The first light emitting stack IL1, the second light emitting stack IL2, and the third light emitting stack IL3 may be sequentially stacked.

The first light emitting stack IL1 may have a structure in which a first hole transport layer, a first organic light emitting layer that emits light of the first color, and a first electron transport layer are sequentially stacked. The second light emitting stack IL2 may have a structure in which a second hole transport layer, a second organic light emitting layer that emits light of the third color, and a second electron transport layer are sequentially stacked. The third light emitting stack IL3 may have a structure in which a third hole transport layer, a third organic light emitting layer that emits light of the second color, and a third electron transport layer are sequentially stacked.

A first charge generation layer for supplying charges to the second light emitting stack IL2 and supplying electrons to the first light emitting stack IL1 may be disposed between the first light emitting stack IL1 and the second light emitting stack IL2. The first charge generation layer may include an N-type charge generation layer that supplies electrons to the first light emitting stack IL1 and a P-type charge generation layer that supplies holes to the second light emitting stack IL2. The N-type charge generation layer may include a dopant of a metal material.

A first charge generation layer for supplying charges to the third light emitting stack IL3 and supplying electrons to the second light emitting stack IL2 may be disposed between the second light emitting stack IL2, and the third light emitting stack IL3. The second charge generation layer may include an N-type charge generation layer that supplies electrons to the second light emitting stack IL2 and a P-type charge generation layer that supplies holes to the third light emitting stack IL3.

The first light emitting stack IL1 may be disposed on the first electrodes AND and may be disposed on the first pixel defining film PDL1. For example, the first light emitting stack IL1 may be disposed on the inner sidewall of the first pixel defining film PDL1. The second light emitting stack IL2 may be disposed on the first light emitting stack IL1. The second light emitting stack IL2 may cover the first light emitting stack IL1 and may be disposed on the first pixel defining film PDL1 in the opening of the pixel defining film PDL. Each of the first light emitting stack IL1 and the second light emitting stack IL2 may be disconnected by the tip structure of the third pixel defining film PDL3 between the neighboring sub-pixels SP1, SP2, and SP3. The third light emitting stack IL3 may be disposed on the second light emitting stack IL2. The third light emitting stack IL3 may not be disconnected by the tip structure of the third pixel defining film PDL3 and may be disposed on the pixel defining film PDL. A void or an empty space may be disposed between the third light emitting stack IL3 and the second pixel defining film PDL2. That is, the first light emitting stack IL1 and the second light emitting stack IL2 may be layers disposed in the opening of the pixel defining film PDL, and the third light emitting stack IL3 may be a layer entirely disposed in the opening of the pixel defining film PDL and on the pixel defining film PDL.

For example, in a three-tandem structure, the tip structure of the pixel defining film PDL may be a structure for disconnecting the first and second light emitting stacks IL1 and IL2, the first charge generation layer, and the second charge generation layer between the neighboring sub-pixels SP1, SP2, and SP3. In the two-tandem structure, the tip structure of the pixel defining film PDL may be a structure for disconnecting the charge generation layer and the lower intermediate layer disposed between the lower intermediate layer and the upper intermediate layer.

The pixel defining film PDL may have a structure in which a plurality of inorganic insulating layers are stacked, and, in some embodiments, may have a structure in which inorganic insulating layers of different materials are alternately stacked. In the process of forming an opening of the pixel defining film PDL, there may be a layer that is etched at a faster rate than other layers stacked in contact according to the etch selectivity depending on the etchant. For example, when the first pixel defining film PDL1 and the third pixel defining film PDL3 include an inorganic insulating material of the same material, and the second pixel defining film PDL2 includes an inorganic insulating material of a different material, the second pixel defining film PDL2 may be etched at a faster rate than the third pixel defining film PDL3 in the process of etching the second pixel defining film PDL2 and the third pixel defining film PDL3, and may be recessed more inward than the third pixel defining film PDL3 to form a tip. Due to the tip structure formed inside the opening of the pixel defining film PDL, the light emitting stacks IL may be disconnected between the different neighboring emission areas EA.

Similarly, in the etching process of the first pixel defining film PDL1, a part of the top surface of the first electrode AND may be etched depending on the etchant. A portion of the top surface of the first electrode AND overlapping the first pixel defining film PDL1 may be partially recessed, and the first pixel defining film PDL1 may form a tip structure.

The number of the light emitting stacks IL1, IL2, and IL3 that emit different lights is not limited to that shown in FIG. 7. For example, the light emitting stack IL may include two intermediate layers. In this case, one of the two intermediate layers may be substantially the same as the first light emitting stack IL1, and the other may include a second hole transport layer, a second organic light emitting layer, a third organic light emitting layer, and a second electron transport layer. In this case, a charge generation layer for supplying electrons to one intermediate layer and supplying charges to the other intermediate layer may be disposed between the two intermediate layers.

In addition, FIG. 7 illustrates that the first to third light emitting stacks IL1, IL2, and IL3 are all disposed in the first emission area EA1, the second emission area EA2, and the third emission area EA3, but the present disclosure is not limited thereto. For example, the first light emitting stack IL1 may be disposed in the first emission area EA1, and may not be disposed in the second emission area EA2 and the third emission area EA3. Furthermore, the second light emitting stack IL2 may be disposed in the second emission area EA2 and may not be disposed in the first emission area EA1 and the third emission area EA3. Further, the third light emitting stack IL3 may be disposed in the third emission area EA3 and may not be disposed in the first emission area EA1 and the second emission area EA2. In this case, first to third color filters CF1, CF2, and CF3 of the optical layer may be omitted, but do not necessarily need to be omitted.

The second electrode CAT may be disposed on the third light emitting stack IL3. The second electrode CAT may be formed of a transparent conductive material (TCO) such as ITO and/or IZO that can transmit light or a semi-transmissive conductive material such as magnesium (Mg), silver (Ag), and/or an alloy of Mg and Ag. When the second electrode CAT is formed of a semi-transmissive conductive material, the light emission efficiency may be improved in each of the first to third sub-pixels SP1, SP2, and SP3 due to a micro-cavity effect.

The encapsulation layer TFE may be disposed on the display element layer EML. The encapsulation layer TFE may include at least one inorganic encapsulation layer TFE1 and TFE3 to prevent oxygen or moisture from permeating into the display element layer EML. In addition, the encapsulation layer TFE may include at least one organic layer to protect the display element layer EML from foreign substances such as dust. For example, the encapsulation layer TFE may include the first inorganic encapsulation layer TFE1, the organic encapsulation layer TFE2, and a second inorganic encapsulation layer TFE3.

The first inorganic encapsulation layer TFE1 may be disposed on the second electrode CAT, the organic encapsulation layer TFE2 may be disposed on the first inorganic encapsulation layer TFE1, and the second inorganic encapsulation layer TFE3 may be disposed on the organic encapsulation layer TFE2. The first inorganic encapsulation layer TFE1 and the second inorganic encapsulation layer TFE3 may be formed of multiple films in which one or more inorganic films of silicon nitride (SiNₓ), silicon oxynitride (SiOₓN_{y}), silicon oxide (SiOₓ), titanium oxide (TiOₓ), and/or aluminum oxide (AlOₓ) layers are alternately stacked. The organic encapsulation layer TFE2 may be a monomer. Alternatively, the organic encapsulation layer TFE2 may be an organic layer such as acryl resin, epoxy resin, phenolic resin, polyamide resin, polyimide resin, and/or the like.

The adhesive layer ADL may be disposed on the encapsulation layer TFE. The adhesive layer ADL may be a layer for bonding the encapsulation layer TFE to a layer disposed thereon. The adhesive layer ADL may be a double-sided adhesive member. In addition, the adhesive layer ADL may be a transparent adhesive member such as a transparent adhesive and/or a transparent adhesive resin.

The color filter layer CFL, the lens array layer LNS, and the cover layer DCL may be disposed on the adhesive layer ADL. The color filter layer CFL, the lens array layer LNS, and the cover layer DCL may constitute an optical layer of the display panel 100.

The color filter layer CFL may include the plurality of color filters CF1, CF2, and CF3 and may be disposed on the adhesive layer ADL. The first color filter CF1 may overlap the first emission area EA1 of the first sub-pixel SP1. The first color filter CF1 may transmit light of the first color, i.e., light of a red wavelength band. The first color filter CF1 may transmit light of the first color from among light emitted from the first emission area EA1.

The second color filter CF2 may overlap the second emission area EA2 of the second sub-pixel SP2. The second color filter CF2 may transmit light of the second color, i.e., light of a green wavelength band. Thus, the second color filter CF2 may transmit light of the second color from among light emitted from the second emission area EA2.

The third color filter CF3 may overlap the third emission area EA3 of the third sub-pixel SP3. The third color filter CF3 may transmit light of the third color, i.e., light of a blue wavelength band. Thus, the third color filter CF3 may transmit light of the third color from among light emitted from the third emission area EA3.

The lens array layer LNS may be disposed on the color filter layer CFL in the display area DAA. The lens array layer LNS may include a plurality of lenses disposed in the display area DAA. The plurality of lenses may be disposed on the first color filter CF1, the second color filter CF2, and the third color filter CF3, respectively. Each of the plurality of lenses may be a structure for increasing a ratio of light directed to the front of the display device 10. Each of the plurality of lenses may have a cross-sectional shape that is convex in an upward direction.

The cover layer DCL may be disposed on the lens array layer LNS. The cover layer DCL may be directly disposed on the plurality of lenses of the lens array layer LNS. The cover layer DCL may have a suitable refractive index (e.g., a predetermined refractive index) so that light travels in the third direction DR3 at an interface between the plurality of lenses and the cover layer DCL. Additionally, the cover layer DCL may be a planarization layer. The cover layer DCL may be an organic layer such as acryl resin, epoxy resin, phenolic resin, polyamide resin, polyimide resin and/or the like.

In one or more embodiments, a polarizing plate may be disposed on the cover layer DCL. The polarizing plate may be a structure for preventing visibility degradation caused by reflection of external light. The polarizing plate may include a linear polarizing plate and a phase retardation film. For example, the phase retardation film may be a λ/4 plate (quarter-wave plate), but is not limited thereto. However, when visibility degradation caused by reflection of external light is sufficiently overcome by the first to third color filters CF1, CF2, and CF3, the polarizing plate may be omitted.

As illustrated in FIG. 7, by forming the light emitting element backplane EBP and the display element layer EML on the semiconductor substrate SSUB on which a plurality of transistors are formed, the size of the plurality of pixels PX may be greatly reduced, so that the display device 10 that displays high-resolution images may be provided.

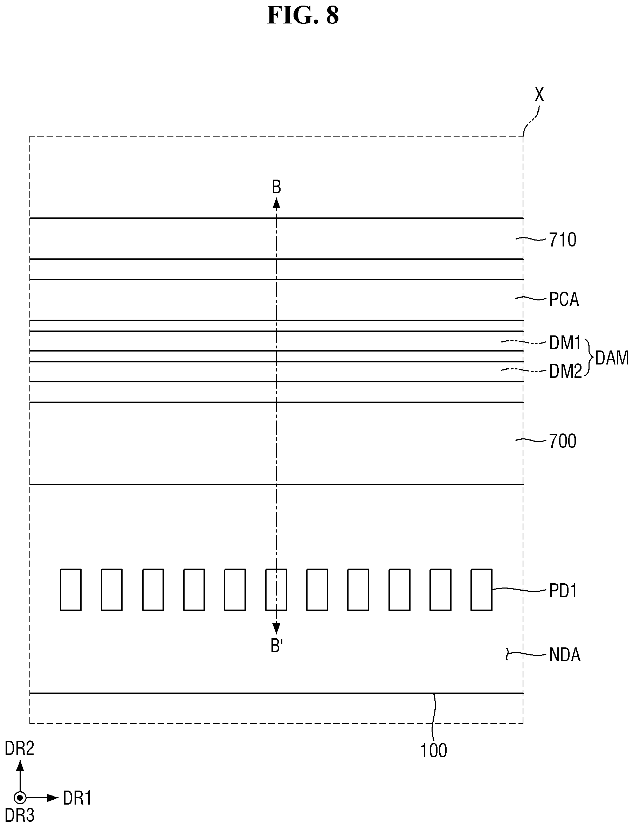

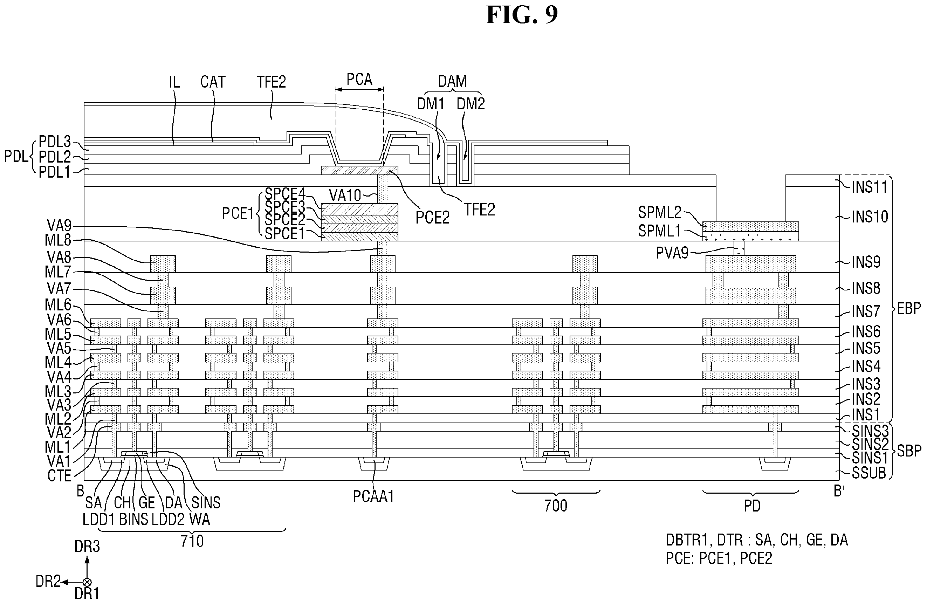

FIG. 8 is an enlarged view showing an area X of FIG. 4. FIG. 9 is a schematic cross-sectional view taken along the line B-B' of FIG. 8.

The area X of FIG. 4 may be an area disposed on the lower side, which is one side of the display area DAA in the second direction DR2. FIGS. 8 and 9 show the first distribution circuit 710, the power connection portion PCA, the dam structure DAM, the data driver 700, and the pad PD disposed on the lower side of the display area DAA.

Referring to FIGS. 8 and 9, the first distribution circuit 710, the power connection portion PCA, the dam structure DAM, the data driver 700, and the pad PD may be sequentially disposed along the second direction DR2 on the lower side of the display area DAA. However, the present disclosure is not limited thereto. In one or more embodiments, the power connection portion PCA may overlap the first distribution circuit 710 or the data driver 700 in the thickness direction (e.g., the third direction DR3), and the dam structure DAM may overlap the first distribution circuit 710 or the data driver 700 in the thickness direction (e.g., the third direction DR3).

The first distribution circuit 710 may include a plurality of first distribution transistors DBTR1. Because each of the plurality of first distribution transistors DBTR1 may be formed substantially the same as the pixel transistors PTR described in conjunction with FIG. 7, a detailed description of the plurality of first distribution transistors DBTR1 will be omitted. In addition, because the first to eighth metal layers ML1 to ML8 and the first to eighth vias VA1 to VA8 electrically connected to the plurality of first distribution transistors DBTR1 are also substantially the same as those described in conjunction with FIG. 8, a description thereof will be omitted.

The power connection portion PCA includes a first power connection area PCAA1 of the semiconductor substrate SSUB, a first power connection electrode PCE1, and a second power connection electrode PCE2.

The first driving voltage VSS may be applied to the first power connection area PCAA1 of the semiconductor substrate SSUB.

The first power connection electrode PCE1 may be disposed on the ninth insulating layer INS9. The first power connection electrode PCE1 may be connected to the first power connection area PCAA1 of the semiconductor substrate SSUB through the first to eighth metal layers ML1 to ML8 and the first to ninth vias VA1 to VA9.

The first power connection electrode PCE1 may include first to fourth sub-power connection electrodes SPCE1 to SPCE4. The first to fourth sub-power connection electrodes SPCE1 to SPCE4 of the first power connection electrode PCE1 may be substantially the same as the first to fourth reflective electrode layers RL1 to RL4 of the reflective electrode layer RL. That is, the first sub-power connection electrode layer SPCE1 may correspond to the first reflective electrode layer RL1, the second sub-power connection electrode layer SPCE2 may correspond to the second reflective electrode layer RL2, the third sub-power connection electrode layer SPCE3 may correspond to the third reflective electrode layer RL3, and the fourth sub-power connection electrode layer SPCE4 may correspond to the fourth reflective electrode layer RL4.

The second power connection electrode PCE2 may be disposed on the eleventh insulating layer INS11. The second power connection electrode PCE2 may be connected to the first power connection electrode PCE1 through the tenth via VA10.

The second power connection electrode PCE2 may include substantially the same material as the first electrode AND of the light emitting element. A part of the top surface of the second power connection electrode PCE2 may be exposed by the opening of the pixel defining film PDL. The second electrode CAT of the light emitting element may extend to the power connection portion PCA, and may be connected to the second power connection electrode PCE2 exposed by the pixel defining film PDL.

The dam structure DAM may include the first dam DM1 and the second dam DM2. Each of the first dam DM1 and the second dam DM2 may have a trench shape that penetrates at least the first pixel defining film PDL1, the second pixel defining film PDL2, and the third pixel defining film PDL3. The first dam DM1 and the second dam DM2 may penetrate the pixel defining film PDL and the eleventh interlayer insulating layer INS11.

In the first dam DM1, the first inorganic encapsulation layer TFE1 may be disposed on the bottom surface thereof, the organic encapsulation layer TFE2 may be disposed on the first inorganic encapsulation layer TFE1, and the second inorganic encapsulation layer TFE3 may be disposed on the organic encapsulation layer TFE2. The organic encapsulation layer TFE2 may be disposed to fill a part of the first dam DM1. In the second dam DM2, the first inorganic encapsulation layer TFE1 may be disposed on the bottom surface thereof, and the second inorganic encapsulation layer TFE3 may be disposed on the first inorganic encapsulation layer TFE1. The organic encapsulation layer TFE2 may not be disposed in the second dam DM2. In the display device 10, the dam structure DAM is composed of two or more dams DM1 and DM2, and the organic encapsulation layer TFE2 may be disposed in the innermost dam, for example, the first dam DM1, to cover it. However, the organic encapsulation layer TFE2 may not be disposed in the outermost dam, for example, the second dam DM2, and may not cover it. Due to the presence of the first dam DM1 and the second dam DM2, the organic encapsulation layer TFE2 may be prevented from flowing to the pad portion PDA to cover the pads PD. The organic encapsulation layer TFE2 may be prevented from covering the pads PD, thus preventing the pads PD from not being able to be electrically connected to the circuit board 300.

The data driver 700 may include a plurality of data transistors DTR. Because each of the plurality of data transistors DTR may be formed substantially the same as the pixel transistors PTR described in conjunction with FIG. 7, a detailed description of the plurality of data transistors DTR will be omitted. In addition, because the first to eighth metal layers ML1 to ML8 and the first to eighth vias VA1 to VA8 electrically connected to the plurality of data transistors DTR are also substantially the same as those described in conjunction with FIG. 7, a description thereof will be omitted.

Each of the pads PD may include a pad metal layer PML. The pad metal layer PML may include a first sub-pad metal layer SPML1 and a second sub-pad metal layer SPML2. The first sub-pad metal layer SPML1 may be formed of copper (Cu), aluminum (Al), tungsten (W), molybdenum (Mo), chromium (Cr), gold (Au), titanium (Ti), nickel (Ni), and/or neodymium (Nd), or an alloy including one or more of them. The second sub-pad metal layer SPML2 may be formed of one of copper (Cu), aluminum (Al), tungsten (W), molybdenum (Mo), chromium (Cr), gold (Au), titanium (Ti), nickel (Ni), and/or neodymium (Nd), and/or an alloy including one or more of them. For example, the first sub-pad metal layer SPML1 may be made of aluminum (Al) and may have a thickness of approximately 12,000 Å. In addition, the second sub-pad metal layer SPML2 may be made of titanium nitride (TiN) and may have a thickness of approximately 600 Å. The thickness of the pad metal layer PML may be greater than the thickness of the reflective electrode layer RL.

A portion of the top surface of the pad metal layer PML of each pad PD may be exposed without being covered by the tenth interlayer insulating layer INS10 and/or the eleventh interlayer insulating layer INS11. The first sub-pad metal layer SPML1 may be connected to a pad via PVA9 that penetrates the ninth insulating layer INS9 to be connected to the eighth metal layer ML8.

The encapsulation layer TFE may also be disposed in a portion of the non-display area NDA located on the lower side of the display area DAA. While the organic encapsulation layer TFE2 of the encapsulation layer TFE is disposed up to the first dam DM1, the inorganic encapsulation layers TFE1 and TFE3 of the encapsulation layer TFE may be disposed up to the outside of the dam structure DAM to form an inorganic junction area.

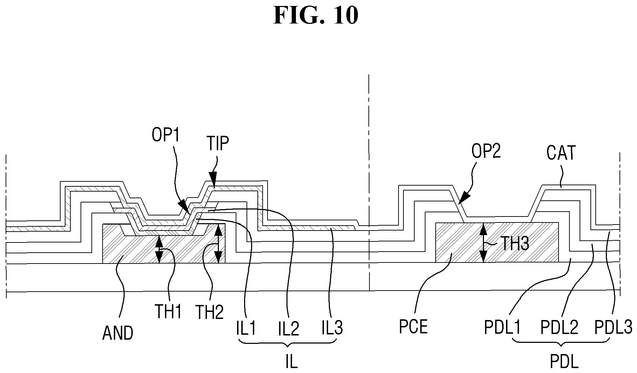

FIG. 10 is a cross-sectional view showing a first electrode and a power connection electrode of a display device according to one or more embodiments.

Referring to FIG. 10, the pixel defining film PDL may include a first opening OP1 overlapping the first electrode AND of the display area DAA, and a second opening OP2 overlapping a power connection electrode PCE of the non-display area NDA. The power connection electrode PCE of FIG. 10 may be substantially the same as the second power connection electrode PCE2 of FIG. 9.

Each of the first electrode AND and the power connection electrode PCE may be disposed on (e.g., at) the same layer and include the same material. For example, each of the first electrode AND and the power connection electrode PCE may be disposed on the eleventh interlayer insulating layer INS11. They may be formed together in the same process and have substantially the same structure.

In the first opening OP1 of the pixel defining film PDL, the second pixel defining film PDL2 may be recessed more inward than the first pixel defining film PDL1 and the third pixel defining film PDL3, and the third pixel defining film PDL3 may form a tip structure. On the other hand, in the second opening OP2 of the pixel defining film PDL, the sidewalls of the first to third pixel defining films PDL1, PDL2, and PDL3 may be placed on (e.g., at) the same plane, and the sidewall of the second opening OP2 may form a smooth surface.

Unlike the light emitting stack IL, the second electrode CAT may be disposed over the entire display area DAA and may extend to the power connection portion PCA to be in contact with the power connection electrode PCE. In the display area DAA, the second electrode CAT may be disposed on the third light emitting stack IL3 and may not be disconnected due to the tip structure of the pixel defining film PDL. However, because the light emitting stack IL is not disposed on the power connection electrode PCE, the second electrode CAT may be disconnected when a tip structure is formed in the opening of the pixel defining film PDL.

In the display device 10, in the opening forming process of the pixel defining film PDL, the opening formed in the display area DAA and the opening formed in the power connection portion PCA of the non-display area NDA may be formed through different processes. Accordingly, in the display area DAA, a tip structure may be formed in the inner sidewall of the opening to disconnect the light emitting stack IL between the different sub-pixels SP1, SP2, and SP3, and in the non-display area NDA, the inner sidewall of the opening may be formed to be smooth to prevent the second electrode CAT from being disconnected.

Each of the first electrode AND and the power connection electrode PCE may be disposed on (e.g., at) the same layer and contain substantially the same material, and due to differences in fabrication processes, a portion of the top surface of the first electrode AND disposed in the display area DAA may be recessed. According to one or more embodiments, a first thickness TH1 of a portion of the first electrode AND overlapping the first opening OP1 may be smaller than a second thickness TH2 of an edge portion of the first electrode AND and a third thickness TH3 of the power connection electrode PCE. During the process of forming the first opening OP1, a portion of the top surface of the first electrode AND may be recessed, and the thickness of the recessed portion may be less than that of an edge of the first electrode AND. Additionally, the first thickness TH1 of the first electrode AND may be smaller than the third thickness TH3 of the power connection electrode PCE disposed on (e.g., at) the same layer. The area of the thinner portion of the first electrode AND may be larger than the opening of the first pixel defining film PDL1. That is, a portion of the first electrode AND overlapping the first pixel defining film PDL1 may be partially thinner, and the first pixel defining film PDL1 may form a tip structure on the first electrode AND.

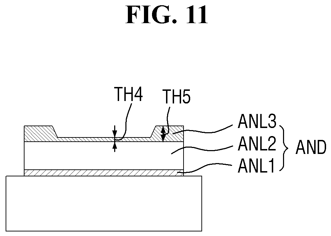

FIG. 11 is a diagram showing in more detail a first electrode of a display device according to one or more embodiments.

Referring to FIG. 11, the first electrode AND may include a plurality of layers ANL1, ANL2, and ANL3. The first electrode AND may include a base layer ANL1, an intermediate layer ANL2, and an upper layer ANL3, and a portion of the top surface that is recessed at the same time as the opening of the pixel defining film PDL is formed may be the upper layer ANL3. A fourth thickness TH4 of a portion of the upper layer ANL3 of the first electrode AND overlapping the first opening OP1 of the pixel defining film PDL may be smaller than a fifth thickness TH5 of the edge portion of a portion of the upper layer ANL3 of the first electrode AND.

The intermediate layer ANL2 of the first electrode AND may include a metal material with high reflectivity. In one or more embodiments, the base layer ANL1 of the first electrode AND may include Ti and/or ITO, the intermediate layer ANL2 may include Al and/or Ag, and the upper layer ANL3 may include TiN and/or ITO. The intermediate layer ANL2 may have a thickness greater than those of the base layer ANL1 and the upper layer ANL3, and may reflect light emitted from the light emitting stack IL and serve as a wire through which electrical signals may flow smoothly. As a portion of the top surface of the first electrode AND is recessed, the thickness of the upper layer ANL3 may decrease, and the reflectivity of light emitted from the light emitting stack IL may increase.

In the display device 10 according to one or more embodiments, the sidewall shapes of the openings OP1 and OP2 of the pixel defining film PDL may be different in the display area DAA and the non-display area NDA. The openings OP1 and OP2 of the pixel defining film PDL may be formed concurrently (e.g., simultaneously) but may have different sidewall shapes through a partial patterning process. Accordingly, in the display area DAA, the light emitting stack IL between the sub-pixels SP1, SP2, and SP3 may be disconnected while the luminance may be improved due to the increase in the light reflectivity of the first electrode AND, and in the non-display area NDA, the second electrode CAT may be prevented from being disconnected.

Hereinafter, a fabrication process of the pixel defining film PDL of the display device 10 will be described with reference to other drawings.

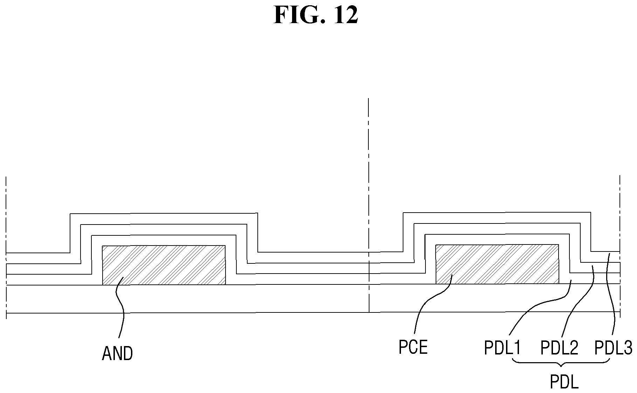

FIGS. 12 - 18 are diagrams partially showing the fabrication process of the display device according to one or more embodiments.

Referring to FIG. 12, the first electrode AND and the power connection electrode PCE are formed, and the first pixel defining film PDL1, the second pixel defining film PDL2, and the third pixel defining film PDL3 to be sequentially stacked on these may be formed. Each of the first pixel defining film PDL1, the second pixel defining film PDL2, and the third pixel defining film PDL3 may include a silicon oxide (SiOₓ) and/or silicon nitride (SiNₓ)-based inorganic insulating material, and a structure in which different materials are alternately stacked may be formed. For example, the first pixel defining film PDL1 and the third pixel defining film PDL3 may include a silicon oxide (SiOₓ)-based inorganic insulating material, and the second pixel defining film PDL2 may include a silicon nitride (SiNₓ)-based inorganic insulating material. The pixel defining film PDL may have a stacked structure of SiOx/SiNx/SiOx. However, the present disclosure is not limited thereto, and the materials of the inorganic insulating materials alternately stacked may be opposite. In this case, the pixel defining film PDL may have a stacked structure of SiNx/SiOx/SiNx.

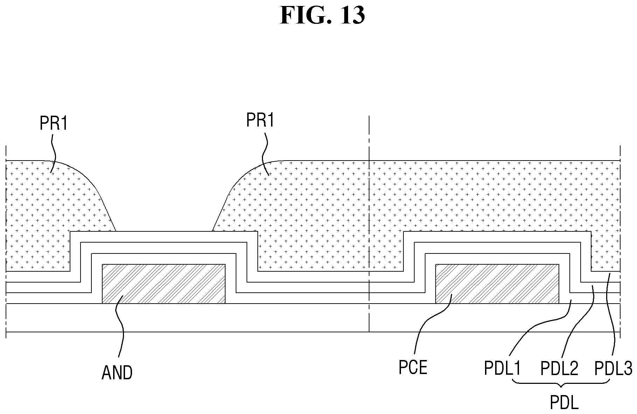

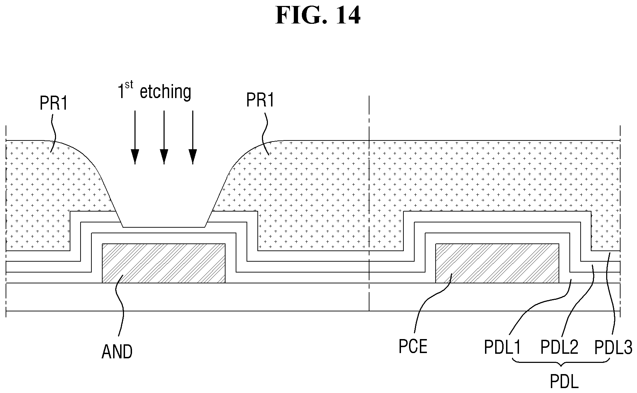

Referring to FIGS. 13 and 14, a first photoresist PR1 is formed on the third pixel defining film PDL3 except for a portion partially overlapping the first electrode AND, and then a first etching process (1^{st} etching) is performed to etch a portion of the second pixel defining film PDL2 and the third pixel defining film PDL3. The first etching process (1^{st} etching) may be performed as a dry etching process and/or a wet etching process. In the first etching process (1^{st} etching), the second pixel defining film PDL2 exposed by the first photoresist PR1 may not be completely removed, and a part thereof may remain.

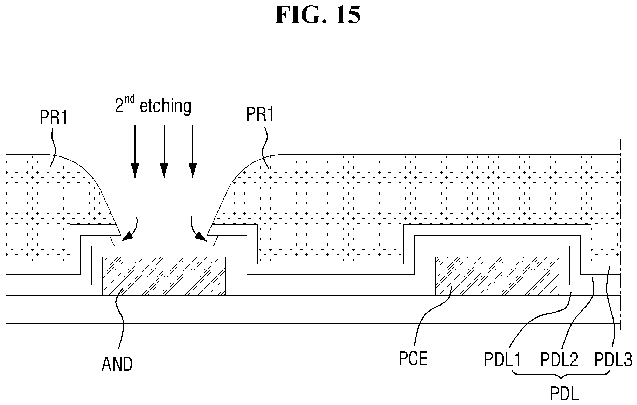

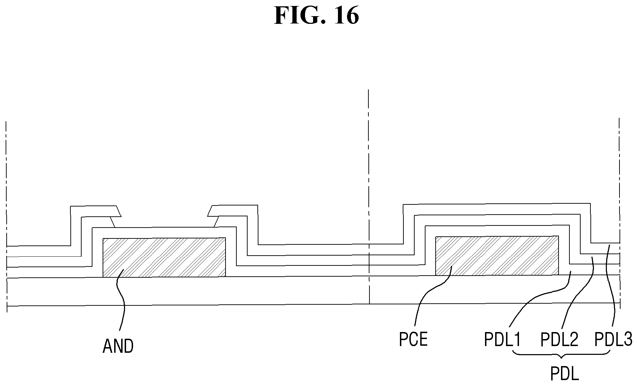

Referring to FIGS. 15 and 16, a second etching process (2^{nd} etching) is performed to remove the remaining portion of the second pixel defining film PDL2 exposed by the first photoresist PR1, and the first photoresist PR1 is removed. The second etching process (2^{nd} etching) may be performed as a wet etching process using an etchant having a faster selectivity for etching the second pixel defining film PDL2 than the third pixel defining film PDL3. For example, when the second pixel defining film PDL2 includes a silicon nitride (SiNx)-based inorganic insulating material and the third pixel defining film PDL3 includes a silicon oxide (SiOx)-based inorganic insulating material, the etchant of the second etching process (2^{nd} etching) may be a phosphoric acid (H₃PO₄)-based etchant. The present disclosure is not limited thereto, and, as described above, when the second pixel defining film PDL2 includes a silicon oxide (SiOx)-based inorganic insulating material, and the third pixel defining film PDL3 includes a silicon nitride (SiNx)-based inorganic insulating material, the etchant of the second etching process (2^{nd} etching) may be an etchant such as TMAH and/or BOE. As the etching rate of the second pixel defining film PDL2 is faster, the second pixel defining film PDL2 disposed below the third pixel defining film PDL3 may be recessed inward, and the third pixel defining film PDL3 may form a tip structure.

In the drawing, it is illustrated that the second etching process (2^{nd} etching) is performed with the first photoresist PR1 remaining, but the present disclosure is not limited thereto. In order to prevent the lifting phenomenon of the first photoresist PR1, the second etching process (2^{nd} etching) may be performed at a high temperature after the photoresist PR1 is completely removed. In this case, the etching process is performed over the entire third pixel defining film PDL3, but the third pixel defining film PDL3 covering the power connection electrode PCE may hardly be etched depending on the etching selectivity to the etchant.

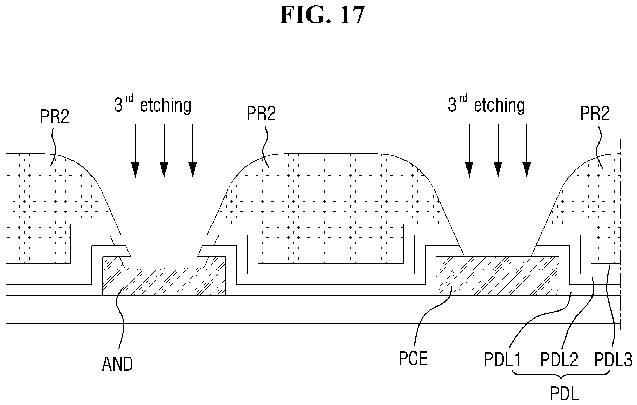

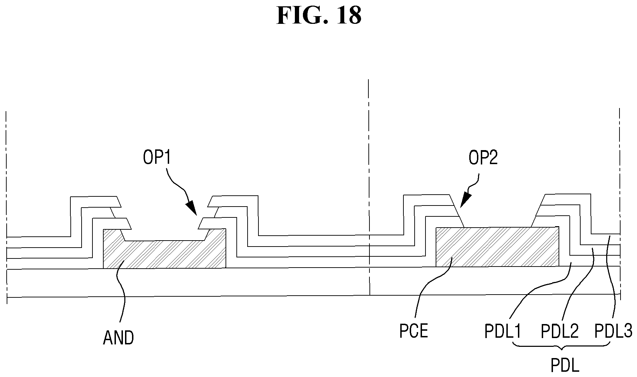

Referring to FIGS. 17 and 18, a second photoresist PR2 is formed on the third pixel defining film PDL3, and a third etching process (3^{rd} etching) that etches the pixel defining film PDL and a part of the first electrode AND is performed. The second photoresist PR2 may be disposed in an area excluding a portion overlapping the first electrode AND and the power connection electrode PCE, and the pixel defining film PDL may be penetrated in the third etching process (3^{rd} etching) to form the first opening OP1 and the second opening OP2. In one or more embodiments, the third etching process (3^{rd} etching) may be performed as a dry etching process and/or a wet etching process.

As the third etching process (3^{rd} etching) is performed on the third pixel defining film PDL3 on the power connection electrode PCE, the first to third pixel defining films PDL1, PDL2, and PDL3 may be etched concurrently (e.g., simultaneously). The sidewall of the second opening OP2 formed by concurrently (e.g., simultaneously) etching the first to third pixel defining films PDL1, PDL2, and PDL3 may have a smooth surface, and the top surface of the power connection electrode PCE may be exposed.

As the third etching process (3^{rd} etching) is performed on the first electrode AND with the second pixel defining film PDL2 recessed inward, the remaining first pixel defining film PDL1 may be penetrated to form the first opening OP1. In addition, because the etching process is performed for a period of time long enough to penetrate the first to third pixel defining films PDL1, PDL2, and PDL3 on the power connection electrode PCE, a part of the top surface of the first electrode AND may be etched. In the present process, in the first electrode AND, the etching rate of the upper layer thereof may be faster than that of the first pixel defining film PDL1, and the thickness thereof may be thinner in an area larger than the area through which the first pixel defining film PDL1 is penetrated. Accordingly, the first pixel defining film PDL1 may also form a tip structure on the first electrode AND.

Next, in one or more embodiments, the light emitting stack IL and the second electrode CAT may be formed on the pixel defining film PDL to form a plurality of light emitting elements in the display area DAA. The second electrode CAT of the light emitting elements may be connected to the power connection electrode PCE at the power connection portion PCA.

In the display device 10 according to one or more embodiments, the pixel defining film PDL may concurrently (e.g., simultaneously) be patterned in the display area DAA and the non-display area NDA during the fabrication process, and the shapes of the openings OP1 and OP2 formed in each area may vary. Accordingly, although the openings OP1 and OP2 of the pixel defining film PDL are formed concurrently (e.g., simultaneously) without an additional mask, they may perform different roles depending on their positions.

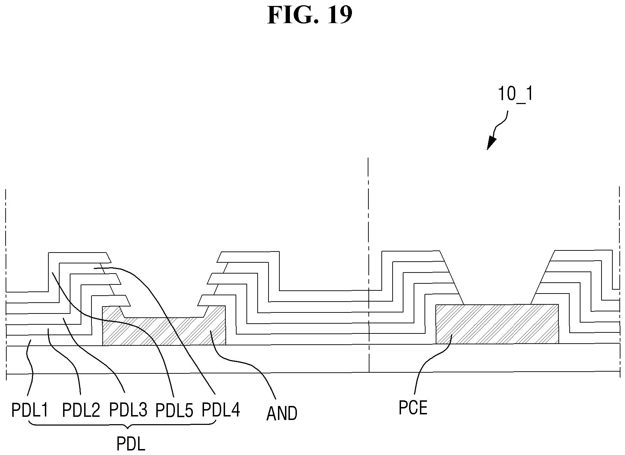

FIG. 19 is a cross-sectional view showing a first electrode and a power connection electrode of a display device according to one or more embodiments.

Referring to FIG. 19, a display device 10_1 may have a five-layer stacked structure in which the pixel defining film PDL further includes a fourth pixel defining film PDL4 and a fifth pixel defining film PDL5. In this case, each of the first to fifth pixel defining films PDL1, PDL2, PDL3, PDL4, and PDL5 may include a silicon oxide (SiOx) and/or silicon nitride (SiNx)-based inorganic insulating material, and may form a structure in which layers of different materials are alternately stacked. The first pixel defining film PDL1, the third pixel defining film PDL3, and the fifth pixel defining film PDL5 may contain the same material, and the second pixel defining film PDL2 and the fourth pixel defining film PDL4 may also contain the same material. For example, the pixel defining film PDL may have a stacked structure of SiOx/SiNx/SiOx/SiNx/SiOx or a stacked structure of SiNx/SiOx/SiNx/SiOx/SiNx. As the pixel defining film PDL has a structure in which a greater number of layers are stacked, a double tip structure may be formed in the first opening OP1 of the pixel defining film PDL. On the other hand, the second opening OP2 may have a smooth surface because the lateral sides of the five pixel defining films PDL1, PDL2, PDL3, PDL4, and PDL5 are formed to be placed on (e.g., at) the same plane.

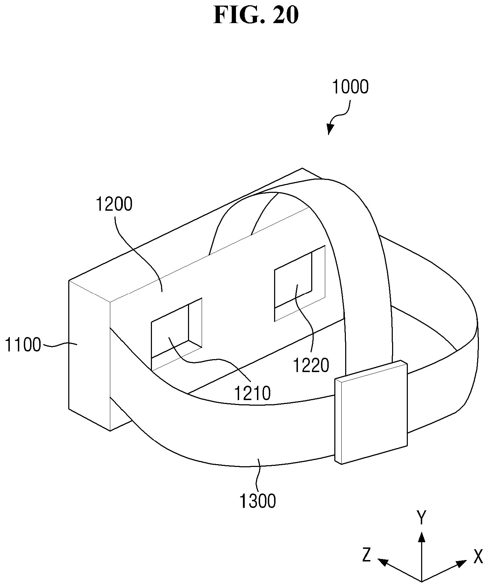

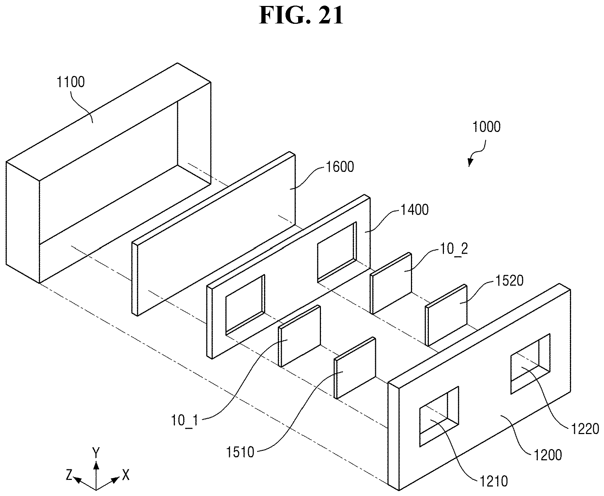

FIG. 20 is a perspective view illustrating a head mounted display device according to one or more embodiments. FIG. 21 is an exploded perspective view showing an example of the head mounted display device of FIG. 20.

Referring to FIGS. 20 and 21, a head mounted display device 1000 according to one or more embodiments includes a first display device 10_1, a second display device 10_2 a display device housing 1100, a housing cover 1200, a first eyepiece 1210, a second eyepiece 1220, a head mounted band 1300, a middle frame 1400, a first optical member 1510, a second optical member 1520, a control circuit board 1600, and a connector.

The first display device 10_1 provides an image to a user's left eye, and the second display device 10_2 provides an image to a user's right eye. Because each of the first display device 10_1 and the second display device 10_2 is substantially the same as the display device 10 described in conjunction with FIG. 1, the description of the first display device 10_1 and the second display device 10_2 will be omitted.

The first optical member 1510 may be disposed between the first display device 10_1 and the first eyepiece 1210. The second optical member 1520 may be disposed between the second display device 10_2 and the second eyepiece 1220. Each of the first optical member 1510 and the second optical member 1520 may include at least one convex lens.

The middle frame 1400 may be disposed between the first display device 10_1 and the control circuit board 1600 and between the second display device 10_2 and the control circuit board 1600. The middle frame 1400 serves to support and fix the first display device 10_1, the second display device 10_2, and the control circuit board 1600.

The control circuit board 1600 may be disposed between the middle frame 1400 and the display device housing 1100. The control circuit board 1600 may be connected to the first display device 10_1 and the second display device 10_2 through the connector. The control circuit board 1600 may convert an image source inputted from the outside into the digital video data DATA, and may transmit the digital video data DATA to the first display device 10_1 and the second display device 10_2 through the connector.

The control circuit board 1600 may transmit the digital video data DATA corresponding to a left-eye image optimized for the user's left eye to the first display device 10_1, and may transmit the digital video data DATA corresponding to a right-eye image optimized for the user's right eye to the second display device 10_2. Alternatively, the control circuit board 1600 may transmit the same digital video data DATA to the first display device 10_1 and the second display device 10_2.

The display device housing 1100 serves to accommodate the first display device 10_1, the second display device 10_2, the middle frame 1400, the first optical member 1510, the second optical member 1520, the control circuit board 1600, and the connector. The housing cover 1200 is disposed to cover one open surface of the display device housing 1100. The housing cover 1200 may include the first eyepiece 1210 at which the user's left eye is disposed and the second eyepiece 1220 at which the user's right eye is disposed. FIGS. 20 and 21 illustrate that the first eyepiece 1210 and the second eyepiece 1220 are disposed separately, but the present disclosure is not limited thereto. The first eyepiece 1210 and the second eyepiece 1220 may be combined into one.

The first eyepiece 1210 may be aligned with the first display device 10_1 and the first optical member 1510, and the second eyepiece 1220 may be aligned with the second display device 10_2 and the second optical member 1520. Accordingly, the user may view the image of the first display device 10_1 magnified as a virtual image by the first optical member 1510 through the first eyepiece 1210, and may view the image of the second display device 10_2 magnified as a virtual image by the second optical member 1520 through the second eyepiece 1220.

The head mounted band 1300 serves to secure the display device housing 1100 to the user's head such that the first eyepiece 1210 and the second eyepiece 1220 of the housing cover 1200 remain disposed on the user's left and right eyes, respectively. When the display device housing 1200 is implemented to be lightweight and compact, the head mounted display device 1000 may be provided with, as shown in FIG. 20, an eyeglass frame instead of the head mounted band 1300.

In addition, the head mounted display device 1000 may further include a battery for supplying power, an external memory slot for accommodating an external memory, and an external connection port and wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, and/or a Bluetooth module.

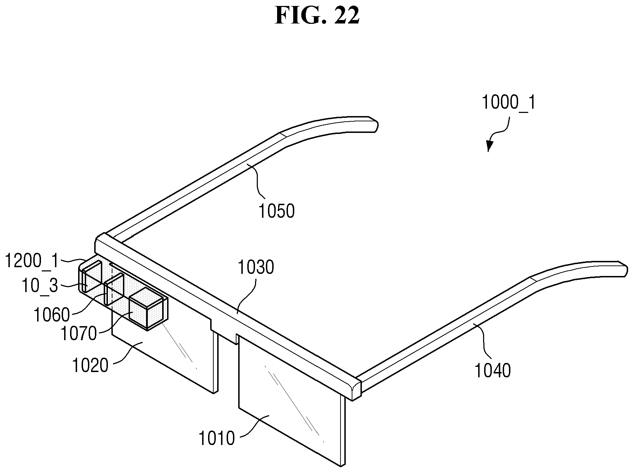

FIG. 22 is a perspective view illustrating a head mounted display device according to one or more embodiments.

Referring to FIG. 22, a head mounted display device 1000_1 according to one or more embodiments may be an eyeglasses-type display device in which a display device housing 1200_1 is implemented in a lightweight and compact manner. The head mounted display device 1000_1 according to one or more embodiments may include a display device 10_3, a left eye lens 1010, a right eye lens 1020, a support frame 1030, temples 1040 and 1050, an optical member 1060, an optical path changing member 1070, and the display device housing 1200_1.

The display device housing 1200_1 may include the display device 10_3, the optical member 1060, and the optical path changing member 1070. An image displayed on the display device 10_3 may be magnified by the optical member 1060, and the optical path may be changed by the optical path changing member 1070 to provide the image to the user's right eye through the right eye lens 1020. As a result, the user may view an augmented reality image, through the right eye, in which a virtual image displayed on the display device 10_3 and a real image seen through the right eye lens 1020 are combined.

FIG. 22 illustrates that the display device housing 1200_1 is disposed at the right end of the support frame 1030, but the present disclosure is not limited thereto. For example, the display device housing 1200_1 may be disposed on the left end of the support frame 1030, and in this case, the image of the display device 10_3 may be provided to the user's left eye. Alternatively, the display device housing 1200_1 may be disposed on both the left and right ends of the support frame 1030, and in this case, the user may view the image displayed on the display device 10_3 through both the left and right eyes.

In concluding the detailed description, those skilled in the art will appreciate that many variations and modifications can be made to the embodiments without substantially departing from the principles and scope of the present disclosure. Therefore, the embodiments of the present disclosure are used in a generic and descriptive sense only and not for purposes of limitation.

## Claims

1. A display device comprising:
a substrate including a display area and a non-display area around the display area;
a plurality of first electrodes spaced from each other on the substrate in the display area;
a power connection electrode on the substrate in the non-display area;
a pixel defining film in the display area and the non-display area and including a plurality of first openings overlapping the first electrodes, and a second opening overlapping the power connection electrode;
a plurality of light emitting stacks on the first electrode in the display area; and
a second electrode on the pixel defining film and the light emitting stack,
wherein the pixel defining film comprises a first pixel defining film, a second pixel defining film on the first pixel defining film, and a third pixel defining film on the second pixel defining film, and
wherein the second pixel defining film is recessed more inward than the third pixel defining film in the first opening, and lateral sides of the first pixel defining film, the second pixel defining film, and the third pixel defining film are at a same plane in the second opening.

2. The display device of claim 1, wherein a thickness of a portion of the first electrode overlapping the first opening is smaller than a thickness of a portion of the power connection electrode overlapping the second opening.

3. The display device of claim 1 or claim 2, wherein a first thickness of a portion of the first electrode overlapping the first opening is smaller than a second thickness of an edge portion of the first electrode.

4. The display device of claim 3, wherein an area of the portion of the first electrode having the first thickness is greater than an area of a portion of the first electrode penetrated by the first opening of the first pixel defining film, wherein the first pixel defining film comprises a tip structure on the first electrode.

5. The display device of claim 3 or claim 4, wherein the first electrode comprises a base layer, an intermediate layer on the base layer, and an upper layer on the intermediate layer, wherein a fourth thickness of a portion of the upper layer that overlaps the first opening is smaller than a fifth thickness of an edge portion of the upper layer; optionally:
wherein the base layer comprises Ti or ITO, the intermediate layer comprises Al or Ag, and the upper layer comprises TiN or ITO.

6. The display device of any preceding claim, further comprising an insulating layer on the substrate,
wherein the first electrode and the power connection electrode are directly on the insulating layer.

7. The display device of any preceding claim, wherein the pixel defining film further comprises a fourth pixel defining film on the third pixel defining film, and a fifth pixel defining film on the fourth pixel defining film, wherein the fourth pixel defining film is recessed more inward than the fifth pixel defining film in the first opening.

8. The display device of any preceding claim, wherein a sidewall of the second opening of the pixel defining film has a smooth surface, and the second electrode covers the second opening and is connected to the power connection electrode.

9. The display device of any preceding claim, wherein the light emitting stack comprises a first light emitting stack, a second light emitting stack on the first light emitting stack, and a third light emitting stack on the second light emitting stack, and
wherein the first light emitting stack and the second light emitting stack are in the first opening, and the first light emitting stacks and the second light emitting stacks disposed in the plurality of first openings, which are adjacent to each other and different from each other, are not connected to each other.

10. The display device of any preceding claim, wherein each of the first pixel defining film, the second pixel defining film, and the third pixel defining film comprises a silicon oxide or silicon nitride-based inorganic insulating material, and the pixel defining film comprises layers comprising different materials that are alternately stacked.

11. The display device of any preceding claim, further comprising a plurality of dam structures in the non-display area, the plurality of dam structures being around the display area, and an encapsulation layer on the second electrode,
wherein each of the plurality of dam structures has a trench shape penetrating the pixel defining film; optionally:
(i) wherein the encapsulation layer comprises a first inorganic encapsulation layer on the second electrode and beyond the dam structure, an organic encapsulation layer on the first inorganic encapsulation layer without covering an outermost dam structure from among the plurality of dam structures, and a second inorganic encapsulation layer on the organic encapsulation layer and the first inorganic encapsulation layer; and/or
(ii) wherein the display device further comprises a plurality of color filters on the encapsulation layer and each overlapping the first electrode, a plurality of lenses on the color filters and in the display area, and a cover layer on the lenses.

12. A method for fabricating a display device, comprising:
forming a first electrode and a power connection electrode on a substrate, and forming a first pixel defining film, a second pixel defining film, and a third pixel defining film covering the first electrode and the power connection electrode;
performing a first etching process of partially etching a portion of the second pixel defining film and the third pixel defining film overlapping the first electrode;
performing a second etching process of etching a portion of the second pixel defining film remaining in the first etching process and forming a tip structure in which a lateral side of the third pixel defining film protrudes beyond the second pixel defining film; and
performing a third etching process of etching the first pixel defining film, the second pixel defining film, and the third pixel defining film to form a first opening exposing a top surface of the first electrode and a second opening exposing a top surface of the power connection electrode,
wherein the first electrode has a thickness of a portion overlapping the first opening, which is smaller than a thickness of a portion overlapping the second opening of the power connection electrode.

13. The method of claim 12, wherein a tip structure of the first pixel defining film and the third pixel defining film is in the first opening, and lateral sides of the first pixel defining film, the second pixel defining film, and the third pixel defining film are at a same plane in the second opening.

14. The method of claim 12 or claim 13, wherein:
(i) the first electrode comprises a base layer, an intermediate layer on the base layer, and an upper layer on the intermediate layer, and a thickness of a portion of the upper layer overlapping the first opening is smaller than a thickness of an edge portion of the upper layer; and/or
(ii) the second etching process is performed as a wet etching process; and/or
(iii) in the third etching process, the first pixel defining film overlapping the first electrode, and a part of the first electrode are etched while the first pixel defining film, the second pixel defining film, and the third pixel defining film overlapping the power connection electrode are etched.

15. A head mounted display device comprising:
a frame mountable on a user's body and corresponding to left and right eyes;
a plurality of display devices in the frame; and
an eyepiece on each of the plurality of display devices,
wherein the display device comprises:
a substrate including a display area and a non-display area around the display area;
a plurality of first electrodes spaced from each other on the substrate in the display area;
a power connection electrode on the substrate in the non-display area;
a pixel defining film in the display area and the non-display area and including a plurality of first openings overlapping the first electrodes, and a second opening overlapping the power connection electrode;
a plurality of light emitting stacks on the first electrode in the display area; and
a second electrode on the pixel defining film and the light emitting stack,
wherein the pixel defining film comprises a first pixel defining film, a second pixel defining film on the first pixel defining film, and a third pixel defining film on the second pixel defining film,
wherein the second pixel defining film is recessed more inward than the third pixel defining film in the first opening, and lateral sides of the first pixel defining film, the second pixel defining film, and the third pixel defining film are at a same plane in the second opening, and
wherein the first electrode has a thickness of a portion overlapping the first opening is smaller than a thickness of a portion of the power connection electrode overlapping the second opening.
